# EUROPÄISCHE PATENTANMELDUNG

(11) **EP 4 170 836 A1**
(43) Veröffentlichungstag der Anmeldung: **26.04.2023**
(21) Anmeldenummer: 22202504.1
(22) Anmeldetag: 19.10.2022
(51) Int. Cl.: H01S 5/02, H01S 5/042, H01S 5/20, H01S 5/227, H01S 5/343

(54) **VORRICHTUNG ZUR ERZEUGUNG EINER LASERSTRAHLUNG MIT EINER LATERAL-CURRENT-INJECTION-LASERANORDNUNG UND EINEM HOHLRAUM, SOWIE VERFAHREN ZUR HERSTELLUNG DERSELBEN**

(30) Priorität: 20.10.2021 DE 102021211848
(71) Anmelder: Fraunhofer-Gesellschaft zur Förderung der angewandten Forschung e.V., 80686 München (DE)
(72) Erfinder: GATZMANN, Jan Gregor, 10587 Berlin (DE); MÖHRLE, Martin, 10587 Berlin (DE)
(74) Vertreter: Zimmermann, Tankred Klaus

(57) **Zusammenfassung**

Ausführungsbeispiele gemäß der vorliegenden Erfindung umfassen eine Vorrichtung zur Erzeugung einer Laserstrahlung mit einem Halbleitersubstrat, einer auf dem Halbleitersubstrat angeordneten Zwischenschicht und einer Lateral-Current-Injection (LCI)-Laseranordnung, die auf der Zwischenschicht angeordnet ist, wobei die Zwischenschicht einen Hohlraum umfasst, der sich zumindest unter einem Laserstreifen der LCI-Laseranordnung erstreckt.

## Beschreibung

### Technisches Gebiet

Ausführungsbeispiele gemäß der vorliegenden Erfindung umfassen eine Vorrichtung zur Erzeugung einer Laserstrahlung mit einer Lateral-Current-Injection-Laseranordnung und einem Hohlraum, sowie ein Verfahren zur Herstellung derselben.

Weitere Ausführungsbeispiele gemäß der vorliegenden Erfindung umfassen ein Verfahren zur Herstellung eines Membran-Laser mit Seiteninjektion auf Indiumphosphid (InP)-Substrat.

### Hintergrund der Erfindung

Moderne Anwendungen wie optische neuronale Netze erfordern neuartige Laserkonzepte in Bezug auf Leistungsverbrauch und Modulationsbandbreite.

Erst seit wenigen Jahren gibt es erfolgreiche Ansätze diese bisher elektronisch realisierten Schaltungen auch in die Photonik zu übertragen. [1] Solche photonisch integrierten Schaltungen (PICs) für "Neuromorphic Photonics" gehören zu den Schlüsseltechnologien einer energieeffizienten und schnellen Informationsverarbeitung überall dort, wo es um höchste Anforderungen an Parallelität und Latenz geht. [2] Diese PICs werden von vielen, auf engem Raum direkt angekoppelten Halbleiterlasern mit optischen Signalen gespeist. Aus der hohen Packungsdichte und den sehr geringen Übertragungswegen ergeben sich für die Halbleiterlaser ganz neue Anforderungen: Wärmeentwicklung und optische Ausgangsleistung müssen um ca. eine Größenordnung reduziert werden, gleichzeitig muss eine hohe Modulationsgeschwindigkeit erreicht werden, was nur durch eine entsprechende Miniaturisierung der Laser erreicht werden kann. Aufgrund von physikalischen Limitierungen ist dies jedoch mit den kommerziell verwendeten Halbleiterlasern prinzipiell nicht möglich.

NTT und Tokyo Institute of Technology zeigen seit 2014, dass sich Lateral Current Injection (LCI-) Membranlaser für solche Anwendungen grundsätzlich gut eignen. [3] [4]

Ein gravierender Nachteil der bisher publizierten LCI-Laserchips ist der aufwändige Herstellungsprozess, der verglichen mit der klassischen BH-Struktur mit zusätzlichen Schwierigkeiten verbunden ist. Hier sind vor allem das selektive epitaktische seitliche Anwachsen von p- und n- dotierten InP-Bereichen sowie die Herstellung der Membran-Struktur zu erwähnen.

Die mit Abstand größte Schwachstelle der bisher gezeigten LCI-Varianten mit Membran-struktur ist allerdings die fehlende Möglichkeit, diese Komponenten monolithisch mit anderen optischen Komponenten auf einem InP-Substrat zu integrieren.

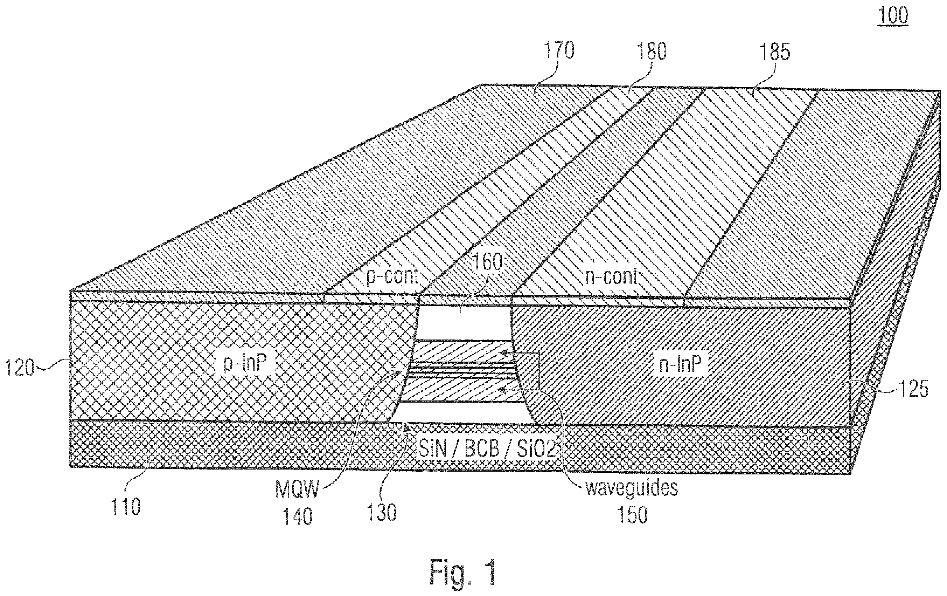

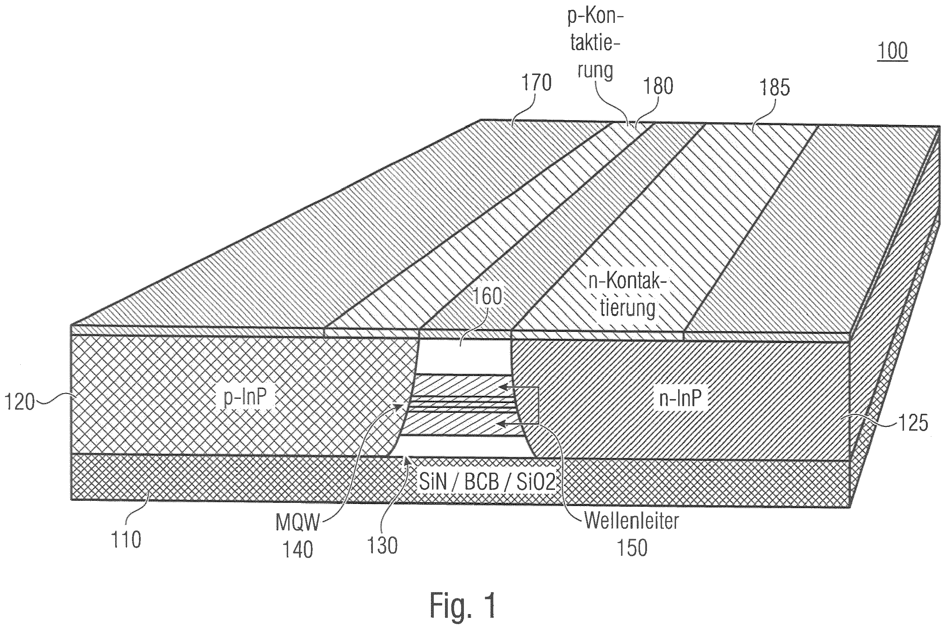

Bei den bisher bekannten Herstellungsmethoden zur Realisierung solcher Membranstrukturlaser wird der gesamte InP-Wafer auf Wafer mit kleinerem Brechungsindex wie Siliziumnitrid oder Siliziumoxid gebondet und anschließend das komplette InP-Substrat durch Abdünnen/Abätzen von der Rückseite her entfernt. Fig. 1 zeigt schematisch, wie die bisher realisierten LCI-Membranlaser prinzipiell aufgebaut sind.

Fig. 1 zeigt eine schematische Seitenansicht einer LCI-Struktur, welche auf niedrigbrechendes Material gebondet wurde. Fig. 1 zeigt einen LCI-Membranlaser 100 mit einem Substrat 110, wobei das Substrat beispielsweise Siliziumnitrid (SiN) oder Siliziumoxid (SiO₂) umfasst und zusätzlich eine Benzocyclobuten (BCB)-Schicht umfassen kann. Auf dem Substrat 110. Auf dem Substrat ist eine Lateral-Current-Injection (LCI)-Laseranordnung umfassend einen ersten p-dotierten Bereich 120 aus Indiumphosphid (p-InP) und einen zweiten n-dotierten Bereich 125 aus Indiumphosphid (n-InP) angeordnet. Zwischen den beiden dotierten Bereichen ist der Laserstreifen 130 der LCI-Laseranordnung angeordnet. Der Laserstreifen 130 umfasst ein Multi-Quantum-Well (MWQ, Multi-Quantentopf) 140, Wellenleiter (waveguides) 150, sowie Bereiche 160 aus Indiumphosphid. Auf der LCI-Laseranordnung ist eine Passivierungsschicht 180, sowie Kontaktierungen 180, 185 für die jeweiligen dotierten Bereiche angeordnet.

Im Hinblick auf die in Fig. 1 gezeigte Struktur von LCI-Membranlasern und den zuvor beschriebenen Problemen besteht ein Bedarf nach einem verbesserten Konzept für derartige Laser.

Aufgabe der vorliegenden Erfindung ist die Bereitstellung eines Konzepts für eine Vorrichtung zur Erzeugung einer Laserstrahlung, sowie eines Herstellungsverfahrens derselben, welches einen verbesserten Kompromiss zwischen der Komplexität des Aufbaus, der Effizienz der Vorrichtung, den Möglichkeiten und Aufwand zur Integration mit weiteren optischen Komponenten und den Herstellungskosten ermöglicht.

Die erfindungsgemäße Aufgabe wird durch die unabhängigen Patentansprüche gelöst. Erfindungsgemäße Weiterbildungen sind in den Unteransprüchen definiert.

### Zusammenfassung der Erfindung

Ausführungsbeispiele gemäß der vorliegenden Erfindung umfassen eine Vorrichtung zur Erzeugung einer Laserstrahlung mit einem Halbleitersubstrat, einer auf dem Halbleitersubstrat angeordneten Zwischenschicht und einer Lateral-Current-Injection (LCI)-Laseranordnung, bspw. eines Membranlasers, die auf der Zwischenschicht angeordnet ist, wobei die Zwischenschicht einen Hohlraum umfasst, der sich zumindest unter einem Laserstreifen der LCI-Laseranordnung erstreckt.

Ausführungsbeispiele gemäß der vorliegenden Erfindung beruhen auf der Idee einen Hohlraum oder eine Hohlraumstruktur, beispielsweise eine Kavität, zumindest unter einem Laserstreifen der LCI-Laseranordnung, oder angrenzend an den Laserstreifen der LCI-Laseranordnung bereitzustellen, sodass der Hohlraum eine optische Begrenzung der erzeugten Laserstrahlung ermöglicht. Dieser Hohlraum wird in einer Zwischenschicht unterhalb der LCI-Laseranordnung, welche eine Opferschicht für einen Ätzprozess zur Herstellung des Hohlraums bilden kann, bereitgestellt.

Somit kann ein zusätzlicher Freiheitsgrad im Hinblick auf das Substrat geschaffen werden. Bspw. kann ein für ein bestimmtes Anwendungsgebiet, oder im Hinblick auf eine vorteilhafte Integration mit anderen Komponenten, vorteilhaftes Substrat verwendet werden, sodass beispielsweise keine signifikanten Einschränkungen in der Wahl des Substrats bezüglich des "optischen confinements" oder anders ausgedrückt, der Eigenschaften des Substrats im Hinblick auf eine optische Begrenzung der erzeugten Laserstrahlung besteht. Damit kann beispielsweise eine entsprechende LCI-Laseranordnung monolithisch mit anderen Komponenten auf einem InP-Substrat integriert werden. In anderen Worten kann eine erfindungsgemäße schwebende Laserstruktur direkt auf einem InP-Substrat hergestellt werden.

Eine monolithische Integration ermöglicht dabei die Reduktion der Herstellungskosten von Bauteilen, welche eine erfindungsgemäße Vorrichtung zur Erzeugung von Laserstrahlung umfassen. Somit können beispielsweise kostengünstig und mit geringem technischen Aufwand Laserkonzepte für photonisch integrierte Schaltungen (PIC) bereitgestellt werden.

Durch den Hohlraum kann ferner die optische Begrenzung der erzeugten Laserstrahlung verbessert werden, sodass die Laserstrahlung geringeren Verlusten unterliegt und so die Effizienz durch die Verbesserung des optischen Confinements in der aktiven Schicht verbessert werden kann.

Ferner können eine Vielzahl erfindungsgemäßer Vorrichtungen zur Erzeugung von Laserstrahlung, bspw. aufgrund des verringerten Energiebedarfs, in Anordnungen mit hoher Packungsdichte und für Anwendungen mit sehr geringen Übertragungswegen verwendet werden. Bspw. kann eine Anordnung erfindungsgemäßer Vorrichtungen PICs speisen oder Teil einer PIC sein, wobei die erfindungsgemäßen Vorrichtungen monolithisch mit weiteren Komponenten auf einem gemeinsamen Substrat integriert sein können. Bei dem Substrat kann es sich bspw. um semi-insulating (halb-isolierendes) InP handeln.

Somit wird deutlich, dass eine erfindungsgemäße Vorrichtung einen verbesserten Kompromiss zwischen der Komplexität des Aufbaus, der Effizienz der Vorrichtung, den Möglichkeiten und Aufwand zur Integration mit weiteren optischen Komponenten und den Herstellungskosten ermöglicht.

Gemäß Ausführungsbeispielen der vorliegenden Erfindung ist der Hohlraum dazu ausgebildet die Laserstrahlung in dem Laserstreifen der LCI-Laseranordnung optisch zu begrenzen. Dadurch kann der Energieverbrauch eines erfindungsgemäßen Lasers verringert werden.

Gemäß Ausführungsbeispielen der vorliegenden Erfindung umfasst die LCI-Laseranordnung einen ersten Bereich mit einer ersten Dotierung, beispielsweise umfassend p-dotiertes InP, und einen zweiten Bereich mit einer zweiten Dotierung, beispielsweise umfassend n-dotiertes InP, wobei die erste und zweite Dotierung unterschiedlich sind und wobei der Laserstreifen der LCI-Laseranordnung lateral zwischen dem ersten Bereich und dem zweiten Bereich der LCI-Laseranordnung angeordnet ist. Dabei ist der Laserstreifen dazu ausgebildet, um basierend auf einem lateral, mittels des ersten und zweiten Bereichs, eingespeisten Strom die Laserstrahlung zu erzeugen.

Durch die Anordnung des Laserstreifens lateral zwischen den dotierten Bereichen können die Ladungsträger lateral aus den dotierten Bereichen in den Laserstreifen zur Erzeugung der Laserstrahlung eingespeist werden. Dadurch kann ein zusätzlicher Freiheitsgrad bei der Auslegung einer solchen Laseranordnung, bspw. im Vergleich zu Lasern mit vertikaler Einspeisung der Ladungsträger, genutzt werden. Beispielsweise können lateral und vertikale Vorrichtungsdesigns vollständig oder partiell entkoppelt werden, sodass bspw. bei einem LCI-Laser mit Ladungsstrom in einer lateralen Richtung der vertikale Aufbau der Vorrichtung zur Erzeugung von Laserstrahlung so ausgebildet sein kann, dass bspw. das MQW und die begrenzenden Schichten im Hinblick auf weitere Parameter, bspw. die modale Verstärkung, optimiert sein können.

Gemäß Ausführungsbeispielen der vorliegenden Erfindung weist die LCI-Laseranordnung zumindest eine Tunnelstruktur auf, wobei die zumindest eine Tunnelstruktur im ersten und/oder im zweiten Bereich der LCI-Laseranordnung angeordnet ist und wobei sich die zumindest eine Tunnelstruktur vom Hohlraum in der Zwischenschicht bis zu der, der Zwischenschicht gegenüberliegenden, Oberfläche der LCI-Laseranordnung erstreckt.

Die Tunnelstruktur ermöglicht zum einen eine einfache Zugangsmöglichkeit, um den Hohlraum unterhalb der aktiven Schicht der Zwischenschicht frei zu ätzen. Zum anderen ermöglicht die Tunnelstruktur ein anschließendes Auffüllen des Hohlraums. Damit können bspw. die optischen Eigenschaften im Hinblick auf eine optische Begrenzung der erzeugten Laserstrahlung eingestellt werden, was die Effizienz des Lasers verbessern kann. Die Tunnelstruktur kann dabei im ersten Bereich oder im zweiten Bereich angeordnet sein. Ferner können eine Vielzahl von Tunnelstrukturen vorhanden sein, bspw. sowohl im ersten als auch im zweiten Bereich. Gemäß Ausführungsbeispielen kann eine Tunnelstruktur oder eine Mehrzahl von Tunnelstrukturen dazu ausgebildet sein oder so angeordnet sein, um eine möglichst gute thermische Ankopplung der LCI-Laseranordnung zu ermöglichen. Eine Tunnelstruktur kann dabei aus einem einzelnen Tunnel oder Loch oder aus einer Vielzahl solcher Elemente bestehen.

Gemäß Ausführungsbeispielen der vorliegenden Erfindung umfasst die Vorrichtung eine Passivierungsschicht, und die Passivierungsschicht ist zumindest teilweise auf der, der Zwischenschicht gegenüberliegenden Oberfläche der LCI Laseranordnung angeordnet. Die Passivierungsschicht kann bspw. Siliziumnitrid (SiN) umfassen und kann sowohl eine elektrische Isolation der Vorrichtung ermöglichen, als auch eine Bereitstellung eines Schutzes gegenüber Umwelteinflüssen auf die Vorrichtung. Die Passivierungsschicht kann insbesondere ein niedrigbrechendes Material, bspw. ein Material mit einem geringen Brechungsindex, umfassen. Dadurch kann bspw. die optische Begrenzung der erzeugten Laserstrahlung verbessert werden.

Weitere Ausführungsbeispielen können auch keine Passivierung aufweisen. Die weiter unten erwähnte optische Begrenzung würde dann (bspw. sogar noch effektiver) auch von der Luft, bspw. als Umgebungsgas, übernommen werden können. Zur Verbesserung des elektrischen und mechanischen Schutzes der Oberfläche oder bspw. zur Gewährleistung des elektrischen und mechanischen Schutzes der Oberfläche können optional Ausführungsbeispiele jedoch eine Passivierungsschicht umfassen, wobei bspw. eine minimal schlechtere Begrenzung in Kauf genommen werden kann.

Gemäß Ausführungsbeispielen der vorliegenden Erfindung umfasst die Vorrichtung eine erste Kontaktierung und eine zweite Kontaktierung, wobei die erste Kontaktierung auf dem ersten Bereich der LCI-Laseranordnung angeordnet ist, und wobei die erste Kontaktierung dazu ausgebildet ist einen elektrischen Kontakt zu dem ersten Bereich der LCI-Laseranordnung zu ermöglichen. Ferner ist die zweite Kontaktierung auf dem zweiten Bereich der LCI-Laseranordnung angeordnet, und die zweite Kontaktierung ist dazu ausgebildet einen elektrischen Kontakt zu dem zweiten Bereich der LCI-Laseranordnung zu ermöglichen.

Die erste und zweite Kontaktierung können bspw. mittels Sputtern und/oder Galvanik aufgebracht werden und ermöglichen die Bereitstellung der elektrischen Anschlüsse für die Vorrichtung, zur Erzeugung der Laserstrahlung und Modulation und Einstellung der Strahlung.

Gemäß Ausführungsbeispielen der vorliegenden Erfindung ist die erste Kontaktierung lateral zwischen der Tunnelstruktur und dem Laserstreifen der LCI-Laseranordnung angeordnet und/oder die zweite Kontaktierung ist lateral zwischen der Tunnelstruktur und dem Laserstreifen der LCI-Laseranordnung angeordnet.

Die Kontaktierung kann jeweils nah an der aktiven Schicht angeordnet sein, um die Verluste an Ladungsträgern gering zu halten. Dadurch kann die Effizienz des Lasers hoch und damit der Energieverbrauch des Lasers gering gehalten werden. Die Tunnelstruktur kann wiederum nah an der ersten und/oder zweiten Kontaktierung angeordnet sein, wiederum bspw. nah an der aktiven Schicht, sodass eine einfache Herstellung des Hohlraums durch ein Ätzverfahren ermöglicht werden kann. Dadurch kann eine erfindungsgemäße Vorrichtung mit geringen Kosten erzeugt werden.

Optional kann die die erste Kontaktierung auch lateral an einer, dem Laserstreifen gegenüberliegenden, Seite der Tunnelstruktur der LCI-Laseranordnung angeordnet sein und ferner kann optional die zweite Kontaktierung lateral an einer, dem Laserstreifen gegenüberliegenden, Seite der Tunnelstruktur der LCI-Laseranordnung angeordnet sein.

Gemäß Ausführungsbeispielen der vorliegenden Erfindung umfasst die Vorrichtung eine Kontaktierungsschicht, wobei die Kontaktierungsschicht ein dotiertes Halbleitermaterial aufweist, und wobei die Kontaktierungsschicht auf der, der Zwischenschicht gegenüberliegenden, Oberfläche des Substrats angeordnet ist.

Ferner umfasst die Kontaktierungsschicht eine dritte Kontaktierung, wobei die dritte Kontaktierung dazu ausgebildet ist einen elektrischen Kontakt zu der Kontaktierungsschicht zu ermöglichen.

Dabei erstreckt sich die erste Kontaktierung vom ersten Bereich der LCI-Laseranordnung bis zur Kontaktierungsschicht, und die dritte Kontaktierung ist über die Kontaktierungsschicht mit der ersten Kontaktierung elektrisch leitfähig verbunden ist.

Alternativ erstreckt sich die zweite Kontaktierung vom zweiten Bereich der LCI-Laseranordnung bis zur Kontaktierungsschicht, und die dritte Kontaktierung ist über die Kontaktierungsschicht mit der zweiten Kontaktierung elektrisch leitfähig verbunden ist.

Die Kontaktierungsschicht kann bspw. n-lnP umfassen. Durch die dritte Kontaktierung kann eine substratrückseitige Kontaktierung, bspw. n-Kontaktierung der LCI Laseranordnung bereitgestellt werden. Dadurch kann eine erfindungsgemäße Vorrichtung bspw. von der Vorderseite und von der Rückseite aus jeweils flächig kontaktiert werden, was eine Integration vereinfachen und die Integrationskomplexität verringern kann.

Gemäß Ausführungsbeispielen der vorliegenden Erfindung umfasst der Laserstreifen der LCI-Laseranordnung zumindest ein Multi-Quantum-Well-Paket; und der Laserstreifen der LCI-Laseranordnung umfasst Wellenleiterschichten.

Durch die Verwendung des Multi-Quantum-Well-Pakets kann eine erfindungsgemäße Vorrichtung zur Erzeugung von Laserstrahlung kurzer Wellenlänge, abhängig von dem Multi-Quantum-Well-Paket verwendet werden, sodass bspw. eine Einschränkung im Hinblick auf die erzeugte Wellenlänge aufgrund der Bandlücke des verwendeten Halbleitermaterials geringer ist als die Abhängigkeit von Eigenschaften, bspw. der Geometrie, des Multi-Quantum-Well-Pakets. Ferner ermöglichen die Verwendung des Multi-Quantum-Well-Paket, als auch der Wellenleiter eine gute Effizienz von erfindungsgemäßen Lasern. Die Wellenleiter können die erzeugte Laserstrahlung innerhalb des Laserstreifens optisch begrenzen und so Verluste verringern.

Darüber hinaus kann bspw. der in den Laserstreifen eingeleitete Strom in das Multi-Quantum-Well Paket eingespeist werden. Eine gezielte Einleitung in das Multi-Quantum-Well Paket kann Vorteile aufweisen.

Die Verstärkung des Lichts kann, bspw. tatsächlich nur, im MQW stattfinden. Dementsprechend kann die "Einprägung" des Stroms auch nur für diesen Bereich relevant sein. Zwar kann auch in die anderen Schichten des Laserstreifens ein Anteil des Stroms injiziert werden, jedoch kann dieser Stromanteil bspw. verloren sein (bspw. dahingehend verloren sein, dass der außerhalb des MQW eingeleitete Strom nicht zu einer Verstärkung der Laserstrahlung führt) und kann daher als parasitär anzusehen sein. Entsprechend kann eine derartige Stromeinprägung den Wirkungsgrad eines erfindungsgemäßen Lasers verbessern.

Ganz allgemein kann das Multi-Quantum-Well Paket (MQW) bspw. den aktiven Bereich des Laserstreifens bilden.

Dementsprechend können auch die angrenzenden ersten und zweiten dotierten Bereiche dazu ausgebildet sein, z.B. bei einer anliegenden Potentialdifferenz, einen Strom so in das MQW einzuprägen, dass bspw. kein oder nur geringere parasitärere Ströme in Bereiche des Laserstreifens eingeleitet werden, welche nicht das MQW umfassen.

Anders ausgedrückt können die angrenzenden ersten und zweiten dotierten Bereiche dazu ausgebildet sein, z.B. bei einer anliegenden Potentialdifferenz, einen Strom so in den Laserstreifen einzuprägen, dass der Großteil des Stroms, bspw. zumindest 60% oder zumindest 80% oder zumindest 90 % oder zumindest 99% des eingeprägten Stroms in das MQW eingeleitet wird.

Gemäß Ausführungsbeispielen kann der Laserstreifen dementsprechend auch so aufgebaut sein, dass ein Großteil eines lateral eingeprägten Stroms durch den Bereich des Laserstreifens geleitet wird, welcher das MQW umfasst.

Gemäß Ausführungsbeispielen der vorliegenden Erfindung sind die Wellenleiterschichten semi-isolierende Wellenleiterschichten, und die semi-isolierenden Wellenleiterschichten sind vertikal oberhalb und unterhalb des zumindest einen Multi-Quantum-Well-Paktes angeordnet. Der Vorteil der Semi-Isolierung der Wellenleiterschichten ist, dass dadurch in diese Bereiche die unerwünschte Ladungsträger-Injektion auf ein Minimum reduziert werden kann und stattdessen stärker auf den Bereich des MQW konzentriert werden kann, wo die Verstärkung stattfindet.

Gemäß Ausführungsbeispielen der vorliegenden Erfindung weist der Hohlraum und/oder die zumindest eine Tunnelstruktur einen Füllstoff auf.

Der Füllstoff kann bspw. ein Gas umfassen, wie z.B. Luft, oder ein flüssiges oder ein festes Material, beispielsweise kann BCB verwendet werden. Bspw. kann die Hohlraumstruktur über die Tunnelstruktur mit dem Füllstoff befüllt werden. Dieser kann bspw. eine Flüssigkeit sein, welche aushärtet oder ausgehärtet wird. Damit kann bspw. die strukturelle Integrität der Vorrichtung verbessert werden. Ferner kann durch das Befüllen der Tunnelstruktur wiederum einen planare Oberfläche geschaffen werden.

Ferner kann durch den Füllstoff die thermische Ankopplung zum Substrat verbessert werden. Da der Laser als "aktives Bauteil" heißer als seine Umgebung (bspw. das Substrat) werden kann und höhere Temperaturn prinzipiell schlecht für die Performance jeglicher Halbleiterlaser sein können, kann es vorteilhaft sein bspw. stets eine möglichst gute thermische Anbindung zu haben. Somit kann bspw. ein Füllstoff eingebracht werden, welcher die Laserstrahlung gut optisch begrenzt, und zugleich eine Möglichkeit bietet die Wärme des Lasers abzuführen.

Ferner kann jedoch auch ein Betrieb bei sehr niedrigen Leistungen und damit einhergehend reduzierter Wärmeentwicklung durch die Hohlraumstruktur allerdings überhaupt erst ermöglicht sein, sodass eine bspw. schlechte Wärmekopplug ein Effekt sein kann, den man bspw. in Kauf nehmen muss (und kann). Anders ausgedrückt kann ein Effizienzgewinn durch die Hohlraumstruktur bspw. im Hinblick auf das optische Confinement mögliche Nachteile bspw. im Hinblick auf die thermische Ankopplung überwiegen.

Gemäß Ausführungsbeispielen der vorliegenden Erfindung ist der Füllstoff dazu ausgebildet die Laserstrahlung in dem Laserstreifen der LCI-Laseranordnung optisch zu begrenzen.

Der Füllstoff kann ein niedrigbrechendes Material sein, also bspw. ein Material mit einem geringen Brechungsindex. Somit kann die im Laserstreifen angrenzende Laserstrahlung optisch begrenzt werden, womit Verluste verringert werden können. Somit kann die erfindungsgemäße Vorrichtung eine gute Effizienz aufweisen.

Gemäß Ausführungsbeispielen der vorliegenden Erfindung ist die Zwischenschicht im Vergleich zu dem ersten und zweiten Bereich der LCI-Laseranordnung selektiv ätzbar.

Dadurch kann die erfindungsgemäße Vorrichtung bspw. mit einem Ätzmittel mit geringem Aufwand bearbeitet werden, sodass das Ätzmittel, eingeleitet über die Tunnelstruktur zur Erzeugung des Hohlraums verwendet werden kann, ohne den ersten und zweiten Bereich der LCI-Anordnung zu beschädigen bspw. im Hinblick auf seine spätere Funktionalität für den Laserstreifen. Somit kann die Vorrichtung mit geringen Kosten hergestellt werden.

Gemäß Ausführungsbeispielen der vorliegenden Erfindung weist das das Substrat Indiumphosphid auf; und/oder der erste und der zweite Bereich der LCI-Laseranordnung weist Indiumphosphid auf. Alternativ oder zusätzlich weist der Laserstreifen der LCI-Laseranordnung Indiumgalliumarsenidphosphid auf und/oder die Passivierungsschicht weist Siliziumnitrid auf. Ferner weist alternativ oder zusätzlich die Kontaktierungsschicht Indiumphosphid mit der ersten oder mit der zweiten Dotierung auf.

Durch die erfindungsgemäße Anordnung der Hohlraumstruktur kann ein Substrat aus Indiumphosphid verwendet werden, womit eine Integration mit anderen optischen Komponenten auf einem gemeinsamen Indiumphosphid-Substrat ermöglicht werden kann. Durch die Materialwahl kann ein erfindungsgemäßer Laser eine gute Effizienz aufweisen, bspw. durch das optische Begrenzen der Laserstrahlung im Laserstreifen durch niedrigbrechendes SiN.

Gemäß Ausführungsbeispielen der vorliegenden Erfindung umfasst die Vorrichtung eine optische Komponente, wobei die optische Komponente und die LCI-Laseranordnung monolithisch auf dem Substrat integriert sind.

Wie zuvor erläutert ermöglicht die Hohlraumstruktur einen Freiheitsgrad in der Wahl des Substrats, sodass Systeme mit optischen Komponenten möglich sind, welche mit geringem Aufwand und damit Kosten auf einem gemeinsamen Substrat verwirklicht werden können.

Gemäß Ausführungsbeispielen der vorliegenden Erfindung ist die optische Komponente eine photonisch integrierte Schaltung und die LCI-Laseranordnung ist optisch mit der photonisch integrierten Schaltung gekoppelt. Ferner ist die LCI-Laseranordnung dazu ausgebildet die Laserstrahlung für die photonisch integrierte Schaltung bereitzustellen.

Durch den erfindungsgemäßen Aufbau können die anfangs erläuterten hohen Anforderungen im Hinblick auf die Wärmeentwicklung und optische Ausgangsleistung, sowie Modulationsgeschwindigkeit erreicht werden, sodass eine Integration in PICs ermöglicht werden kann.

Weitere Ausführungsbeispiele gemäß der vorliegenden Erfindung umfassen ein Verfahren zur Herstellung einer Vorrichtung zur Erzeugung einer Laserstrahlung umfassend (a) Erzeugen einer Zwischenschicht auf einem Halbleitersubstrat, (b) Erzeugen einer Lateral-Current-Injection (LCI)-Laseranordnung auf der Zwischenschicht und (c) Erzeugen eines Hohlraums in der Zwischenschicht, wobei sich der Hohlraum zumindest unter einem Laserstreifen der LCI-Laseranordnung erstreckt.

Verfahren gemäß der vorliegenden Erfindung beruhen auf den selben, analogen oder gleichen Überlegungen wie eine zugehörige erfindungsgemäße Vorrichtung. Folglich können alle zuvor im Kontext einer Vorrichtung beschriebenen Merkmale, und Funktionalitäten analog oder entsprechend in ein zugehöriges Verfahren integriert, oder für ein zugehöriges Verfahren angewendet oder verwendet werden, sowohl individuell als auch in Kombination. Folglich kann ein korrespondierendes Verfahren oder ein korrespondierender Verfahrensschritt auch gleiche oder analoge Vorteile einer zugehörigen Vorrichtung, bzw. einem zugehörigen Vorrichtungsmerkmal aufweisen.

Gemäß Ausführungsbeispielen der vorliegenden Erfindung umfasst der Schritt (b) ferner (b1) Erzeugen einer Schichtfolge auf der Zwischenschicht, wobei die Schichtfolge eine Mehrzahl von Schichten eines Laserstreifens der LCI-Laseranordnung umfasst, (b2) Dünnen eines Teils der Schichtfolge in einem ersten und zweiten Bereich der Schichtfolge (410), so dass der Laserstreifen der LCI-Laseranordnung definiert ist, (b3) Anordnen eines Halbleitermaterials mit einer ersten Dotierung in dem ersten Bereich, so dass ein erster Bereich der LCI-Laseranordnung definiert ist, und (b4) Anordnen eines Halbleitermaterials mit einer zweiten, von der ersten Dotierung unterschiedlichen Dotierung, in dem zweiten Bereich, so dass ein zweiter Bereich der LCI-Laseranordnung definiert ist.

Beim Herstellungsprozess kann die Schichtfolge in einem ersten und zweiten Bereich ausgedünnt werden. In den ausgedünnten oder verdünnten, oder abgetragenen Bereichen der Schichtfolge können anschließend die dotierten Halbleitermaterialien angeordnet werden. Bspw. durch nur ein teilweises Abtragen oder Ausdünnen der Schichtfolge kann eine erfindungsgemäßen Vorrichtung mit geringem Zeit- und Kostenaufwand hergestellt werden. Die Bereiche, in der dann zuvor die Schichtfolge abgetragen wurde können nach dem Anordnen des jeweiligen dotierten Halbleitermaterials den ersten und zweiten Bereich der LCI-Laseranordnung bilden.

Gemäß Ausführungsbeispielen der vorliegenden Erfindung umfasst der Schritt (b2) ein Entfernen, bspw. ein vollständiges Entfernen, des Teils der Schichtfolge im ersten und zweiten Bereich der Schichtfolge, um einen ersten und zweiten Bereich der Zwischenschicht freizulegen.

Das Dünnen eines Teils der Schichtfolge kann so ausgeführt werden, dass ein erster und zweiter Bereich der Zwischenschicht freigelegt wird. Das Entfernen eines Teilbereichs der Schichtfolge muss jedoch nicht zwangsläufig zum Freiliegen der Zwischenschicht führen. Gemäß Ausführungsbeispielen kann das Entfernen auch wie zuvor beschrieben bis zu einer etwas geringeren Tiefe als bis zur Zwischenschicht erfolgen. Für den Fall eines vollständigen Freilegens eines ersten und zweiten Bereichs der Zwischenschicht kann anschließend auf diesen Bereichen das jeweilige dotierte Halbleitermaterial angeordnet werden. Das dotierte Halbleitermaterial kann damit wiederum in dem ersten und zweiten Bereich der Schichtfolge angeordnet sein, in denen zuvor die Schichtfolge entfernt wurde und kann somit den ersten und zweiten Bereich der LCI-Laseranordnung bilden.

Gemäß Ausführungsbeispielen der vorliegenden Erfindung umfasst die Schichtfolge zumindest zwei Halbleitermaterialien mit unterschiedlichen Bandlücken.

Durch die Verwendung einer Schichtfolge mit Halbleitermaterialien unterschiedlicher Bandlücke werden weitere Freiheitsgrade für die Optimierung einer erfindungsgemäßen Vorrichtung geschaffen, sodass die jeweilige Materialwahl anwendungsspezifisch getroffen werden kann. Insbesondere können dadurch in der Schichtfolge sowohl der der MQW, als auch die Wellenleiter bereitgestellt werden. Somit kann der Laserstreifen mit geringer Komplexität und geringem Herstellungsaufwand erzeugt werden.

Gemäß Ausführungsbeispielen der vorliegenden Erfindung umfassen die Schritte (b3) und (b4) jeweils ein epitaktisches Aufwachsen des Halbleitermaterials mit der ersten/zweiten Dotierung in dem ersten/zweiten Bereich.

Das dotierte Halbleitermaterial kann somit epitaktisch in dem ersten und zweiten Bereich der Schichtfolge angewachsen werden, in denen zuvor die Schichtfolge entfernt wurde. Durch ein epitaktisches Aufwachsen können Halbleiterbereiche mit präzise eingestellten Eigenschaften erzeugt werden. So können bspw. Dotierprofile mit hoher Genauigkeit eingestellt werden. Ferner können durch Epitaxie abrupte Übergange der Dotierstoffkonzentration und auch besonders reine Halbleiterstrukturen erzeugt werden.

Gemäß Ausführungsbeispielen der vorliegenden Erfindung umfasst der Schritt (b2) ein Erzeugen einer Ätzmaske, durch lithographisches Verfahren, auf zumindest einen Teil der Schichtfolge.

Anders ausgedrückt umfasst der Schritt (b2) das Erzeugen von Ätzmasken durch lithographische Verfahren. Lithographische Verfahren ermöglichen die Erzeugung von präzise platzierten und definierten Maskierungen (Ätzmasken) für die folgenden Ätzverfahren, sodass bspw. erfindungsgemäße Vorrichtungen mit sehr genau definierten Geometrien erzeugt werden können.

Gemäß Ausführungsbeispielen der vorliegenden Erfindung umfasst der Schritt (b) ferner (β1) Erzeugen einer Schichtfolge auf der Zwischenschicht, wobei die Schichtfolge eine Mehrzahl von Schichten eines Laserstreifens der LCI-Laseranordnung umfasst, (β2) Aufbringen einer ersten Ätzmaske, durch ein lithographisches Verfahren, auf die Schichtfolge, (β3) Dünnen des unmaskierten Teils der Schichtfolge in einem ersten Bereich der Schichtfolge, (β4) epitaktisches Aufwachsen eines Halbleitermaterials mit einer ersten Dotierung in dem ersten Bereich, so dass ein erster Bereich der LCI-Laseranordnung definiert ist, (β5) Entfernen der ersten Ätzmaske, (β6) Aufbringen einer zweiten Ätzmaske, durch ein lithographisches Verfahren, auf einen Bereich der Schichtfolge, welcher den Laserstreifen der LCI-Laseranordnung bildet, und auf das Halbleitermaterial mit der ersten Dotierung im ersten Bereich der LCI-Laseranordnung, (β7) Dünnen des unmaskierten Teils der Schichtfolge in einem zweiten Bereich der Schichtfolge, (β8) epitaktisches Aufwachsen eines Halbleitermaterials mit einer zweiten, von der ersten Dotierung unterschiedlichen Dotierung, in dem zweiten Bereich, so dass ein zweiter Bereich der LCI-Laseranordnung definiert ist, und (β9) Entfernen der zweiten Ätzmaske.

Der Schritt (β3) kann bspw. ein Entfernen des unmaskierten Teils der Schichtfolge, um einen ersten Bereich der Zwischenschicht freizulegen, umfassen. Entsprechend kann der Schritt (β7) ein Entfernen des unmaskierten Teils der Schichtfolge, um einen zweiten Bereich der Zwischenschicht freizulegen, umfassen. Gemäß Ausführungsbeispielen kann das Dünnen eines Teils der Schichtfolge, auf welchem keine Ätzmaske angeordnet ist, ein vollständiges, bspw. bis zur darunter liegenden Zwischenschicht reichendes, Entfernen eines Teils der Schichtfolge umfassen oder ein teilweises oder partielles Entfernen bzw. Ausdünnen. Die Schichtfolge kann bspw. oberhalb des ersten und zweiten Bereichs der Zwischenschicht ausgedünnt werden, sodass im Folgenden oberhalb dieser Bereiche das jeweilige dotierte Halbleitermaterial (in dem ersten und zweiten Bereich der Schichtfolge, welche gedünnt wurde) durch epitaktisches Aufwachsen aufgebracht werden kann.

Die Herstellung unter Verwendung von Ätzmasken mittels lithographischer Verfahren ermöglicht eine kosteneffiziente und präzise einstellbare Möglichkeit eine erfindungsgemäße Vorrichtung zu fertigen.

Gemäß Ausführungsbeispielen der vorliegenden Erfindung umfasst das Aufbringen der ersten und/oder zweiten Ätzmaske ferner ein Aufbringen einer Materialschicht auf zumindest einen Teil der Schichtfolge, ein Erzeugen einer Ätzmaske durch ein lithographisches Verfahren auf zumindest einen Teil der Materialschicht, und ein partielles Entfernen der Materialschicht außerhalb des zumindest einen Teils der Materialschicht.

Die Materialschicht kann als Passivierung gegenüber den Ätzmasken oder in anderen Worten der Maskierung dienen, bspw. um die Belastung der vorhandenen Schichten im Hinblick auf die wieder zu entfernenden Ätzmasken gering zu halten, sodass keine oder nur wenige unerwünschte Beschädigungen oder Veränderungen durch die Lithographie- und Ätzschritte erzeugt werden. Die Materialschicht kann bspw. Siliziumnitrid und/oder Siliziumoxid umfassen.

Anders ausgedrückt kann die Erzeugung der Ätzmasken durch lithographische Verfahren auf einer Materialschicht wie Siliziumnitrid und/oder Siliziumoxid erfolgen, welche zuvor auf die Schichtfolge aufgebracht wurde und welche anschließend partiell (entsprechend der lithographischen Maske) wieder entfernt wird. Erst dieses Resultat dient dann z.B. als Ätzmaske für folgende Schritte, wie bspw. das Dünnen des unmaskierten Teils der Schichtfolge in einem ersten Bereich der Schichtfolge, bspw. um einen ersten Bereich der Zwischenschicht freizulegen.

Gemäß Ausführungsbeispielen der vorliegenden Erfindung umfasst das Dünnen eines Teils der Schichtfolge ein gerichtetes Trockenätzverfahren. Durch ein Trockenätzverfahren kann bspw. die Tunnelstruktur mit definierter Geometrie und geringem Zeitaufwand erzeugt werden.

Gemäß Ausführungsbeispielen der vorliegenden Erfindung umfasst der Schritt (b) oder der Schritt (c) ferner ein Aufbringen einer Passivierungsschicht auf die LCI-Laseranordnung.

Wie zuvor beschrieben kann die Passivierungsschicht ein niedrigbrechendes Material umfassen, bspw. Siliziumnitrid (SiN), und kann sowohl eine elektrische Isolation der Vorrichtung, als auch eine Bereitstellung eines Schutzes gegenüber Umwelteinflüssen auf die Vorrichtung ermöglichen. Dadurch kann bspw. die optische Begrenzung der erzeugten Laserstrahlung verbessert werden.

Gemäß Ausführungsbeispielen der vorliegenden Erfindung umfasst der Schritt (b) oder der Schritt (c) ferner Aufbringen einer ersten Kontaktierung auf den ersten Bereich der LCI-Laseranordnung, wobei die erste Kontaktierung dazu ausgebildet ist einen elektrischen Kontakt zu dem Halbleitermaterial mit der ersten Dotierung zu ermöglichen, und Aufbringen einer zweiten Kontaktierung auf den zweiten Bereich der LCI-Laseranordnung, wobei die zweite Kontaktierung dazu ausgebildet ist einen elektrischen Kontakt zu dem Halbleitermaterial mit der zweiten Dotierung zu ermöglichen.

Die elektrische Kontaktierung kann bei der Erzeugung der Lateral-Current-Injection (LCI)-Laseranordnung oder beim Erzeugen eines Hohlraums aufgebracht werden. Die Kontaktierungen können durch Metallkontakte gebildet werden, welche bspw. auf dem n-leitenden und p-leitenden Bereich seitlich entlang des Laserstreifens, bspw. mittels Sputtern und/oder Galvanik angeordnet werden können.

Gemäß Ausführungsbeispielen der vorliegenden Erfindung umfasst der Schritt (c) ferner (c1) Erzeugen zumindest einer Tunnelstruktur im ersten und/oder im zweiten Bereich der LCI-Laseranordnung, wobei sich die zumindest eine Tunnelstruktur von der, der Zwischenschicht gegenüberliegenden, Oberfläche der LCI-Laseranordnung bis zur Zwischenschicht erstreckt, um die Zwischenschicht zumindest teilweise freizulegen, und (c2) Erzeugen des Hohlraums in der Zwischenschicht unter Verwendung der zumindest einen Tunnelstruktur.

Durch die Tunnelstruktur besteht eine einfache Möglichkeit den Hohlraum unterhalb des Laserstreifens frei zu ätzen. Ferner kann über die Tunnelstruktur ein Füllstoff in den Hohlraum eingebracht werden, um bspw. bestimmte Eigenschaften des Lasers zu verbessern, bspw. um die optische Begrenzung der erzeugten Laserstrahlung im Laserstreifen durch die Verwendung eines niedrigbrechenden Füllstoffs zu ermöglichen, um Verluste zu verringern und damit eine hohe Effizienz des Lasers zu ermöglichen.

Ferner kann der Füllstoff einen Verbesserung der Stabilität und/oder eine Verbesserung der Wärmeabfuhr ermöglichen. Bspw. kann es sich bei dem Füllstoff auch um ein Umgebungsgas, wie bspw. Luft handeln. Dementsprechend kann ein Einbringen eines Füllstoffs ebenfalls dadurch gekennzeichnet sein, dass ein Umgebungsgas in die Hohlraumstruktur eindringt.

Luft als Füllstoff kann hierbei bspw. im Hinblick auf einen optische Begrenzung sehr gut oder sogar am besten sein, sodass bspw. ein Freilassen des Hohlraums, sodass Umgebungsluft in den Hohlraum eindringen kann ein bevorzugtes Ausführungsbeispiel bildet.

Gemäß Ausführungsbeispielen der vorliegenden Erfindung umfasst wobei der Schritt (c1) ferner (c11) Aufbringen einer dritten Ätzmaske durch lithographische Verfahren auf der LCI-Laseranordnung, und (c12) Erzeugen der zumindest einen Tunnelstruktur im ersten und/oder zweiten Bereich der LCI-Laseranordnung, mittels eines Trockenätzverfahrens. Darüber hinaus umfasst der Schritt (c2) ferner (c21) Einbringen einer selektiven Ätzlösung in die zumindest eine Tunnelstruktur, und (c22) Ätzen der Zwischenschicht unter Verwendung der Ätzlösung zur Erzeugung des Hohlraums.

Durch die Prozessschritte kann die erfindungsgemäße Vorrichtung mit geringem Aufwand hergestellt werden. Durch die Verwendung ausgereifter Verfahren wie der Lithographie und einer Kombination von Trockenätzverfahren und der Verwendung einer Ätzlösung kann die erfindungsgemäße Vorrichtung mit präzise definierten Geometrien erzeugt werden.

Gemäß Ausführungsbeispielen der vorliegenden Erfindung umfasst das Aufbringen der dritten lithographischen Ätzmaske ferner ein Aufbringen einer Materialschicht auf zumindest einen Teil der LCI-Laseranordnung, ein Erzeugen einer Ätzmaske durch ein lithographisches Verfahren auf zumindest einen Teil der Materialschicht, und ein partielles Entfernen der Materialschicht außerhalb des zumindest einen Teils der Materialschicht.

Wie zuvor beschrieben kann die Materialschicht als Passivierung gegenüber der Maskierung (Ätzmaske) dienen, um die Belastung der vorhandenen Schichten im Hinblick auf die wieder zu entfernende Maskierung gering zu halten, sodass keine oder nur wenige unerwünschte Beschädigungen oder Veränderungen durch die Lithographie- und Ätzschritte erzeugt werden.

Gemäß Ausführungsbeispielen der vorliegenden Erfindung umfasst das Verfahren ferner (d1) Auffüllen des Hohlraums und/oder der zumindest einen Tunnelstruktur mit einem flüssigen Füllstoff, und (d2) Aushärten des Füllstoffs.

Dadurch kann der Hohlraum bspw. ganzheitlich aufgefüllt werden und dennoch die strukturelle Integrität der Vorrichtung gewährleistet werden.

### Figurenkurzbeschreibung

Beispiele gemäß der vorliegenden Offenbarung werden nachfolgend Bezug nehmend auf die beiliegenden Figuren näher erläutert. Hinsichtlich der dargestellten schematischen Figuren wird darauf hingewiesen, dass die dargestellten Funktionsblöcke sowohl als Elemente oder Merkmale der offenbarungsgemäßen Vorrichtung als auch als entsprechende Verfahrensschritte des offenbarungsgemäßen Verfahrens zu verstehen sind, und auch entsprechende Verfahrensschritte des offenbarungsgemäßen Verfahrens davon abgeleitet werden können. Es zeigen:
- Fig. 1: eine schematische Seitenansicht einer LCI-Struktur, welche auf niedrigbrechendes Material gebondet wurde;
- Fig. 2: eine schematische Seitenansicht einer Vorrichtung zur Erzeugung einer Laserstrahlung gemäß Ausführungsbeispielen der vorliegenden Erfindung; und
- Fig. 3: eine schematische Seitenansicht einer Vorrichtung zur Erzeugung einer Laserstrahlung mit zusätzlichen optionalen Merkmalen gemäß Ausführungsbeispielen der vorliegenden Erfindung;
- Fig. 4: eine schematische Seitenansicht einer Vorrichtung zur Erzeugung einer Laserstrahlung mit einer rückseitigen Kontaktierung gemäß Ausführungsbeispielen der vorliegenden Erfindung;
- Fig. 5: eine schematische Seitenansicht seiner Vorrichtung mit einer optische Komponente gemäß Ausführungsbeispielen der vorliegenden Erfindung;
- Fig. 6: ein schematisches Blockdiagramm eines Verfahren zur Herstellung einer Vorrichtung zur Erzeugung einer Laserstrahlung gemäß Ausführungsbeispielen der vorliegenden Erfindung;
- Fig. 7: schematische Seitenansichten von Herstellungsschritten eines Verfahrens gemäß der vorliegenden Erfindung zur Herstellung einer Vorrichtung zur Erzeugung einer Laserstrahlung; und
- Fig. 8: eine schematische Seitenansicht einer alternativen Ausführungsform der Vorrichtung aus Fig. 3, bei der die Schichtfolge nur jeweils partiell entfernt wurde, gemäß Ausführungsbeispielen der vorliegenden Erfindung.

### Detaillierte Beschreibung der Beispiele gemäß den Figuren

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen oder ähnlichen Bezugszeichen versehen sind, so dass die in unterschiedlichen Ausführungsbeispielen dargestellte Beschreibung dieser Elemente untereinander austauschbar ist bzw. aufeinander angewendet werden kann.

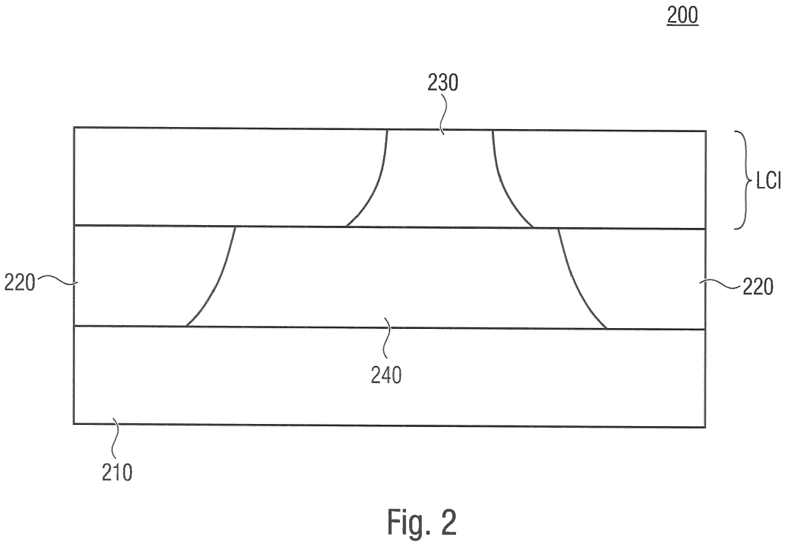

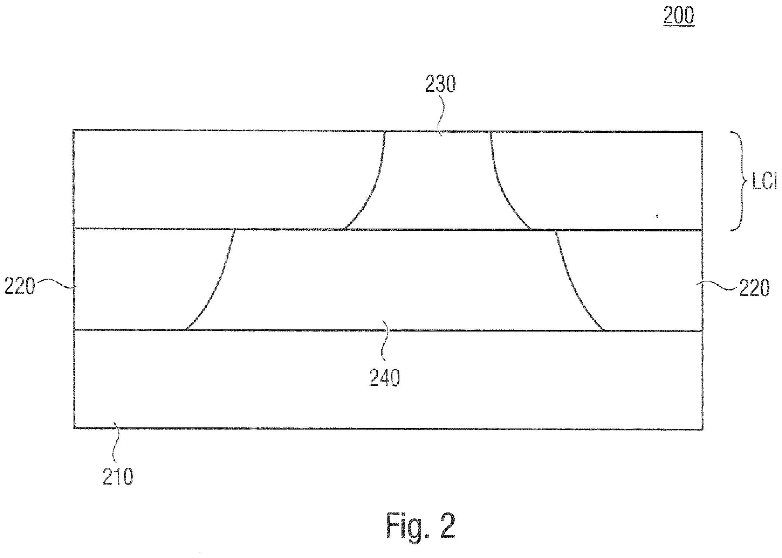

Fig. 2 zeigt eine schematische Seitenansicht einer Vorrichtung zur Erzeugung einer Laserstrahlung gemäß Ausführungsbeispielen der vorliegenden Erfindung. Fig. 2 zeigt die Vorrichtung 200 mit einem Halbleitersubstrat 210, einer auf dem Halbleitersubstrat angeordneten Zwischenschicht220, einer Lateral-Current-Injection (LCI)-Laseranordnung LCI, welche auf der Zwischenschicht angeordnet ist, mit einem Laserstreifen 230, und einen Hohlraum 240, der sich in der Zwischenschicht 220 unter dem Laserstreifen 240 der Laseranordnung erstreckt.

Ladungsträger können lateral über die seitlichen Bereiche der LCI-Laseranordnung in den Laserstreifen 230 gespeist werden, um die Laserstrahlung zu erzeugen. Um eine hohe Effizienz zu ermöglichen ist es vorteilhaft an den Laserstreifen angrenzenden Bereich so auszubilden, dass die Laserstrahlung möglichst nicht in unerwünschter Weise aus dem Laserstreifen 230 ausgekoppelt wird und damit verloren geht. Der Hohlraum 240 ermöglicht dieses "optische confinement" der Laserstrahlung in den Laserstreifen 240 bspw. unabhängig oder zumindest näherungsweise unabhängig von der Wahl des Substratmaterials. Somit kann ein Substrat 210 verwendet werden, welche bspw. keine optimalen Eigenschaften im Hinblick auf eine optische Begrenzung der Laserstrahlung aufweist, aber für eine Integration mit weiteren optischen Bauelementen gut geeignet ist, wie bspw. InP (Indiumphosphid), oder SI-InP (semi-insulating InP).

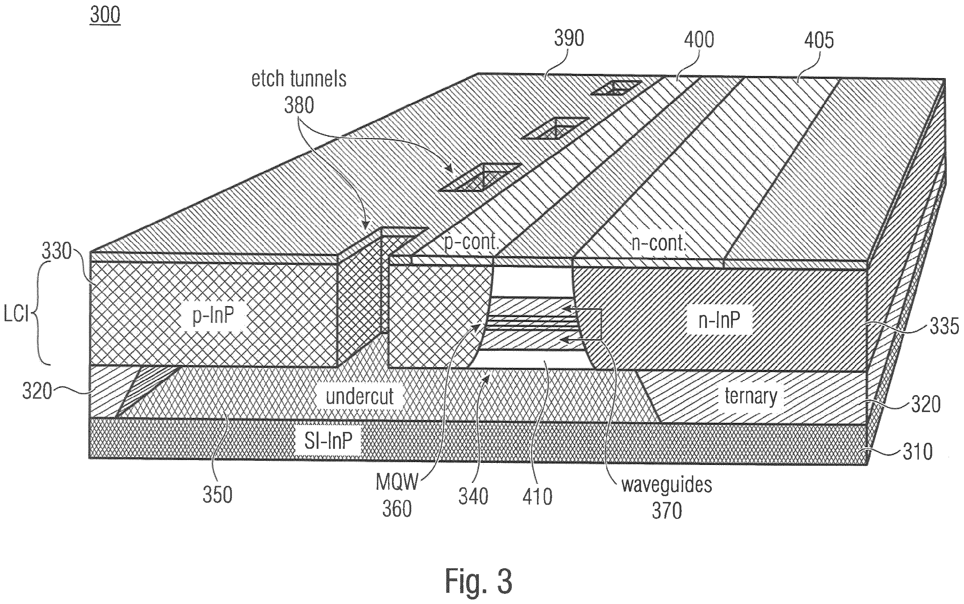

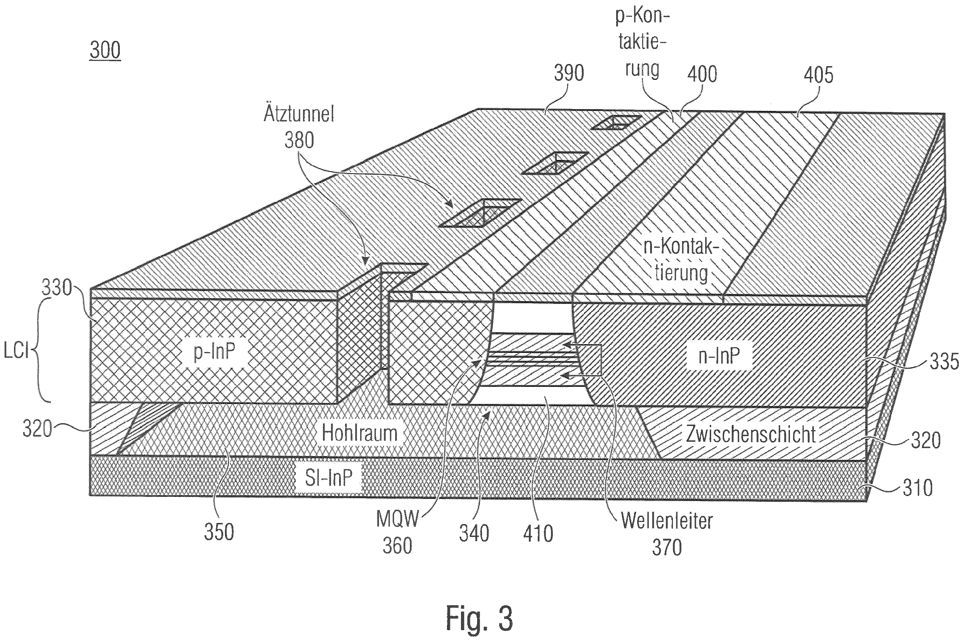

Fig. 3 zeigt eine schematische Seitenansicht einer Vorrichtung zur Erzeugung einer Laserstrahlung mit zusätzlichen optionalen Merkmalen gemäß Ausführungsbeispielen der vorliegenden Erfindung. Fig. 3 zeigt ein Beispiel eines erfindungsgemäßen Schemas eines Lateral Current injection Laserchips mit unterätztem Wellenleiter. Anders ausgedrückt umfassen Ausführungsbeispiele LCI-Laserchips mit lokal unterhöhlter Membranstruktur. Fig. 3 zeigt eine Vorrichtung 300 mit einem Halbleitersubstrat 310, wobei das Halbleitersubstrat 310 optional semi-insulating InP umfasst. Auf dem Halbleitersubstrat 310 ist eine Zwischenschicht (ternary) 320 angeordnet. Auf der Zwischenschicht 320 wiederum ist eine Lateral-Current-Injection (LCI)-Laseranordnung, also bspw. die Membranstrkutur, angeordnet.

Die LCI-Anordnung umfasst einen ersten Bereich (p-InP) 330 mit einer ersten Dotierung (hier als Beispiel eine p-Dotierung), und einen zweiten Bereich (n-InP) 335, mit einer zweiten Dotierung (hier als Beispiel eine n-Dotierung). Der Laserstreifen 340 ist zwischen dem ersten Bereich 330 und dem zweiten Bereich 335 der LCI-Laseranordnung angeordnet. Über die unterschiedlich dotierten Bereiche 330, 335 kann ein Strom lateral in den Laserstreifen 340 eingespeist werden, oder für den Laserstreifen 340 eine Spannung bereitgestellt werden, die zu einem Speisestrom führt. Dabei ist der Laserstreifen 340 dazu ausgebildet, um mittels des bereitgestellten Stroms eine Laserstrahlung zu erzeugen. Der Strom wird dabei lateral, oder einfacher ausgedrückt in der Seitenansicht von Fig. 3 von der Seite aus, in den Laserstreifen 340 eingeprägt. Damit verfügt eine erfindungsgemäße Vorrichtung über die zuvor erläuterten Freiheitsgrade im Hinblick auf die Auslegung der Vorrichtung in der Vertikalen, da von dort aus kein Strom eingespeist wird, wie bei Lasern mit vertikaler Stromeinprägung.

Zwischen Halbleitersubstrat 310 und LCI-Laseranordnung, zumindest im Bereich des Laserstreifens 340 der LCI-Laseranordnung ist ein Hohlraum (undercut) 350 in der Zwischenschicht 320 angeordnet. Der Hohlraum 350 ist dabei dazu ausgebildet die im Laserstreifen 340 erzeugte Laserstrahlung in dem Laserstreifen der LCI-Laseranordnung optisch zu begrenzen. Beispielsweise wird die Laserstrahlung durch den Hohlraum 350 in dem Laserstreifen gehalten, sodass möglichst wenig erzeugte Strahlung ungewollt in das Substrat ausgekoppelt wird und verloren geht. Damit kann ein hoher Wirkungsgrad erzielt werden.

Zur Erzeugung der Laserstrahlung umfasst der Laserstreifen optional ein oder mehrere Multi-Quantum-Well-Pakete (MQW) 360, welche den aktiven Bereich des Laserstreifens bilden können, und Wellenleiterschichten (waveguides) 370. Wie bereits zuvor erläutert, können die dotierten Bereiche 330, 335 dazu ausgebildet sein einen Speisestrom so in den Lasersteifen einzuprägen, dass der Speistrom größtenteils (bspw. zu zumindest 60% oder zu zumindest 80% oder zu zumindest 90 % oder zu zumindest 99%) in das MQW 360 eingeprägt wird. Alternativ oder zusätzlich kann das MQW 360 so in dem Laserstreifen 340 zwischen den dotierten Bereichen 330, 335 und Wellenleitern 370 angeordnet sein, dass der Großteil eines durch die dotierten Bereiche eingeprägten Speisestroms durch das MQW geleitet wird. Dies kann bspw. Vorteile aufweisen, da die Verstärkung des Lichts hauptsächlich oder sogar bspw. ausschließlich im MQW 360 stattfinden kann. Dement-sprechend kann es vorteilhaft sein, einen Strom bspw. nur oder hauptsächlich in diesen Bereich 360 einzuprägen. Zwar kann auch in die anderen Schichten des Laserstreifens 340 ein Anteil des Stroms abgeleitet werden, jedoch kann dieser Stromanteil parasitäre Verluste bilden, da die damit übertragene Energie bspw. nicht zur Erzeugung von Laserstrahlung im MQW 360 genutzt werden kann.

Dementsprechend kann wie zuvor erläutert über die unterschiedlich dotierten Bereiche 330, 335 ein Strom lateral in das MQW 360 eingespeist werden, oder für das MQW 360 eine Spannung bereitgestellt werden, die zu einem Speisestrom führt. Dabei kann das MQW 360 dazu ausgebildet sein, um mittels des bereitgestellten Stroms eine Laserstrahlung zu erzeugen. Der Strom wird dabei lateral, oder einfacher ausgedrückt in der Seitenansicht von Fig. 3 von der Seite aus, in das MQW 360 eingeprägt.

Die Wellenleiterschichten 370 können dabei als semi-isolierende Wellenleiterschichten ausgebildet sein. Die Wellenleiterschichten ermöglichen die optische Begrenzung der erzeugten Laserstrahlung im Laserstreifen 340, um Verluste zu verringern. Die Wellenleiterschichten 370 können um die MWQ-Pakete 360 herum angeordnet sein, bspw. senkrecht bezüglich der Substratoberfläche oberhalb und unterhalb des zumindest einen MWQ-Pakets 360, bspw. sodass die Laserstrahlung effizient begrenzt wird, aber ebenfalls der Speisestrom von den dotierten Bereichen 330, 335 gut eingespeist werden kann. Dementsprechend kann eine Speisung des MQW 360 lateral und eine optische Begrenzung vertikal erfolgen. Der erste und zweite Bereich 330, 335 kann dabei jedoch ebenfalls dazu ausgebildet sein die Laserstrahlung optisch in dem aktiven Beriech 360 zu begrenzen.

Der Hohlraum 350 kann dabei optional einen Füllstoff aufweisen. Der Füllstoff kann dabei bspw. ein Gas wie Luft sein. Jedoch sind auch flüssige und/oder feste Füllstoffe möglich, bspw. ein flüssiger Füllstoff der aushärtbar ist und im ausgehärteten Zustand zur Stabilität der Anordnung beitragen kann. Der Füllstoff bietet ferner den Vorteil zur optischen Begrenzung der erzeugten Lasterstrahlung im Laserstreifen 340 ausgelegt werden zu können. So kann ein Füllstoff verwendet werden, der zu sehr geringen Verlusten im Hinblick auf die erzeugte Laserstrahlung führt.

Die Vorrichtung 300 umfasst ferner eine Tunnelstruktur 380, umfassend einen oder mehrere Tunnel, wie bspw. Ätztunnel (etch tunnels). In Fig. 3 sind als Beispiel 4 Ätztunnel gezeigt, jedoch kann eine Tunnelstruktur auch nur über einen Tunnel verfügen (oder mehr als 4 Ätztunnel). Optional, wie gezeigt, kann die Tunnelstruktur 380 nur in einem der beiden Bereiche 330, 335 angeordnet sein. Dabei können Tunnel einer oder mehrerer Tunnelstrukturen aber auch in beiden Bereichen 330, 335 angeordnet sein. Die Tunnelstruktur 380 verbindet eine Oberfläche der Vorrichtung 300 mit dem Hohlraum 350.

Wie in Fig. 3 gezeigt kann sich die Tunnelstruktur dabei vom Hohlraum bis über die Oberfläche der LCI-Anordnung hinaus durch eine zusätzliche optionale Passivierungsschicht, 390 erstrecken. Die Passivierungsschicht 390 ist zumindest teilweise auf der, der Zwischenschicht gegenüberliegenden Oberfläche der LCI Laseranordnung angeordnet. Damit können die dotierten Bereiche 330 und 335 insbesondere elektrisch abgeschirmt werden, sodass keine oder zumindest nur möglichst geringe Leckströme entstehen können.

Die Vorrichtung 300 weist ferner eine erste Kontaktierung 400 und eine zweite Kontaktierung 405 auf. Die erste Kontaktierung 400 ist auf einem Teil des Bereichs mit der ersten Dotierung 330 aufgebracht und bildet eine elektrisch leitfähige Verbindung zu dem als Beispiel p-dotierten Halbleiter. Die zweite Kontaktierung 405 ist auf einem Teil des Bereichs mit der zweiten Dotierung 335 aufgebracht und bildet eine elektrisch leitfähige Verbindung zu dem als Beispiel n-dotierten Halbleiter. Über die elektrischen Kontaktierungen kann ein externer Speisestrom über den ersten und zweiten dotierten Bereich 330, 335 in das MQW 360 eingespeist werden.

Wie zusätzlich optional in Fig. 3 gezeigt kann ist die erste Kontaktierung 400 gemäß Ausführungsbeispielen lateral zwischen der Tunnelstruktur 380 und dem Laserstreifen 340 der LCI-Laseranordnung angeordnet sein. Für den Fall weiterer Tunnelstrukturen oberhalb des n-dotierten Bereichs ist die zweite Kontaktierung gemäß Ausführungsbeispielen ebenfalls lateral zwischen der Tunnelstruktur und dem Laserstreifen der LCI-Laseranordnung angeordnet.

Optional ist die Zwischenschicht 320 im Vergleich zu dem ersten und zweiten Bereich 330, 335 der LCI-Laseranordnung selektiv ätzbar. Die Zwischenschicht kann bspw. im Vergleich zu dem ersten und zweiten Bereich 330, 335 bspw. sensitiv bezüglich unterschiedlicher Ätzmittel sein.

Wie in Fig. 3 gezeigt kann der Laserstreifen 340 der Vorrichtung 300 eine Schichtfolge 410 umfassen. Die Schichtfolge 410 umfasst dabei eine Mehrzahl von Schichten eines Laserstreifens der LCI-Laseranordnung, beispielsweise das MQW-Paket 360 und die Wellenleiterschicht 370.

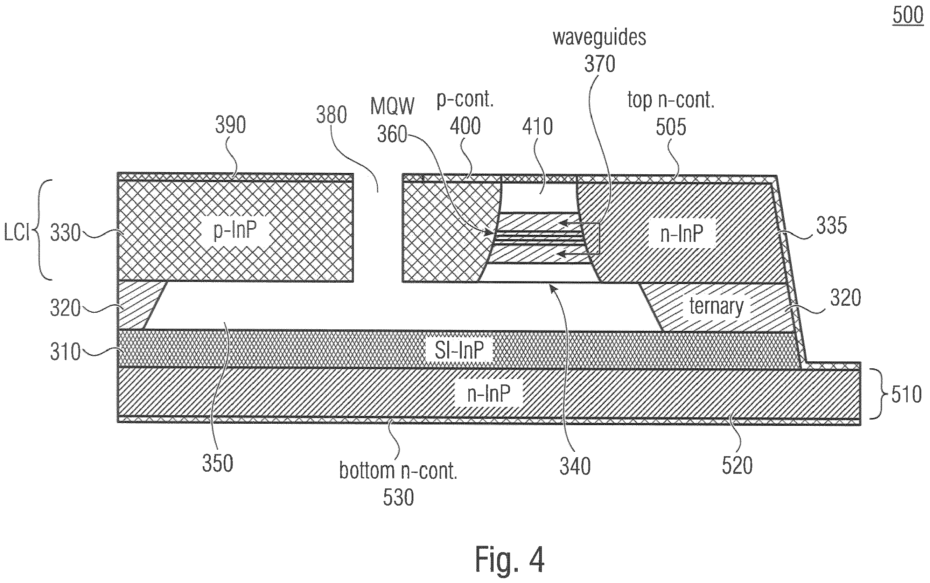

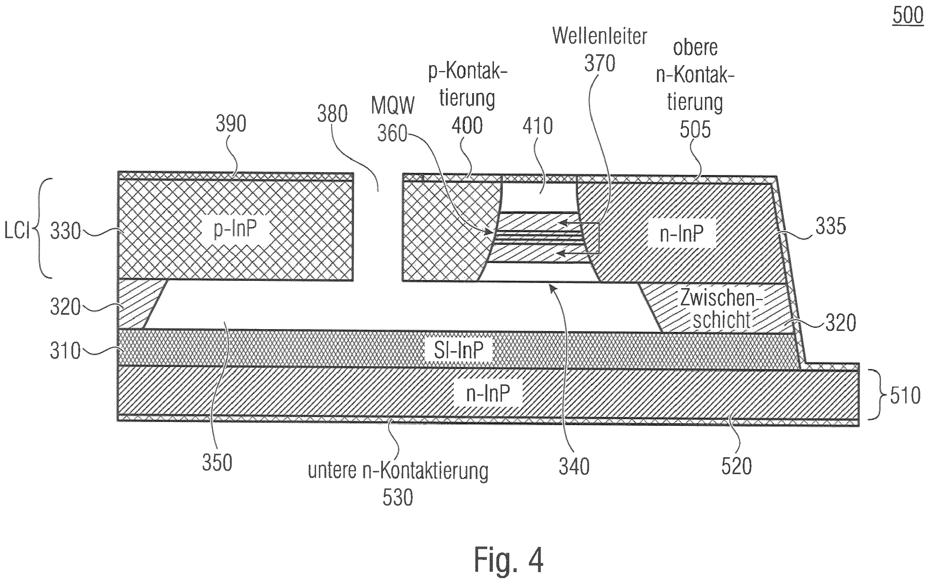

Fig. 4 zeigt eine schematische Seitenansicht einer Vorrichtung zur Erzeugung einer Laserstrahlung mit einer rückseitigen Kontaktierung gemäß Ausführungsbeispielen der vorliegenden Erfindung. In anderen Worten zeigt Fig. 4 eine erfindungsgemäße Realisierung eines rückseitigen n-Kontaktes bei einem LCI-Laser. Fig. 4 zeigt die Vorrichtung 400 mit den bereits zuvor im Kontext von Fig. 3 beschriebenen Elementen. Gemäß dem in Fig. 4 gezeigten Ausführungsbeispiel können erfindungsgemäße Vorrichtungen eine rückseitige Kontaktierung umfassen. Dazu umfasst Vorrichtung 500 eine Kontaktierungsschicht 510 (n-lnP + bottom n-cont.). Die Kontaktierungsschicht 510 weist ein dotiertes Halbleitermaterial 520 (n-InP, hier als Beispiel n-dotiertes Indiumphosphid) auf und ist auf der, der Zwischenschicht 320 gegenüberliegenden, Oberfläche des Substrats 310 angeordnet. Auf dem dotierten Halbleitermaterial 510 ist eine dritte Kontaktierung 530 (bottom n-cont.) aufgebracht.

Die dritte Kontaktierung 530 stellt dabei über das dotierte Halbleitermaterial 520 eine elektrische Verbindung zu der Kontaktierung 505 (top n-cont.) des zweiten dotierten Bereichs 335 her. Eine entsprechende Kontaktierung kann analog zur Herstellung eines rückseitigen Kontakts mit dem p-dotierten Bereich 330 ausgebildet sein.

Dadurch können die Kontakte zu den dotierten Bereichen jeweils von Vorder- und Rückseite erfolgen, sodass insbesondere die rückseitige Kontaktierung, also bspw. eine Kontaktierung der dritten Kontaktierung 530 flächig erfolgen kann.

In anderen Worten kann eine substratrückseitige n-Kontaktierung der Laser, wie in Fig.4 dargestellt, gemäß Ausführungsbeispielen, bspw. bei Verwendung eines n-InP-Substrates ermöglicht werden.

Allgemein können bspw. folgende Materialien verwendet sein: Das Substrat 310 und/oder der erste und der zweite Bereich 330, 335 der LCI-Laseranordnung können Indiumphosphid aufweisen. Der Laserstreifen der LCI-Laseranordnung 340 kann Indiumgalliumarsenidphosphid aufweisen und die Passivierungsschicht Siliziumnitrid. Alternativ oder zusätzlich kann die Kontaktierungsschicht 510 oder das dotierte Halbleitermaterial 520 Indiumphosphid mit der ersten oder mit der zweiten Dotierung aufweisen.

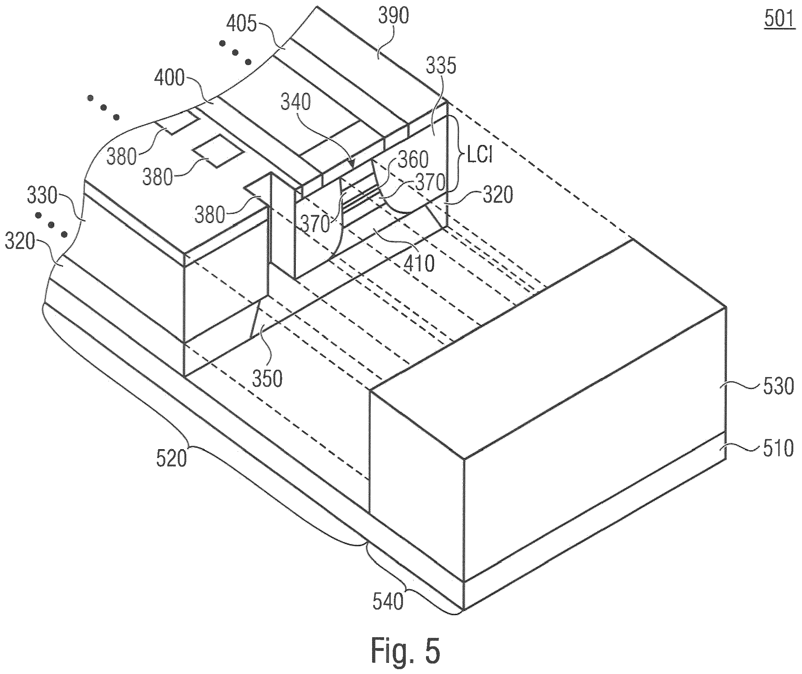

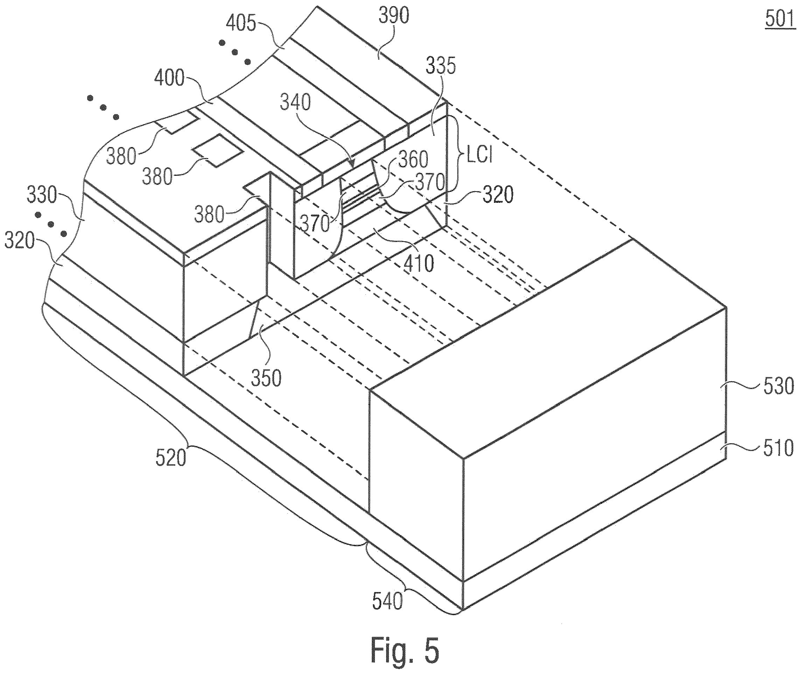

Fig. 5 zeigt eine schematische Seitenansicht einer Vorrichtung mit einer optische Komponente gemäß Ausführungsbeispielen der vorliegenden Erfindung. Fig. 5 zeigt Vorrichtung 501, welche das Halbleitersubstrat 510 umfasst. Substrat 510 bildet ein gemeinsames Substrat für Abschnitt 520 der Vorrichtung, welche zur Erzeugung der Laserstrahlung ausgebildet ist und die zuvor erläuterten Elemente umfasst und die optische Komponente 530, welche im Abschnitt 540 angeordnet ist. Die optische Komponente 530 und die LCI-Laseranordnung sind dabei monolithisch auf dem Substrat 510 integriert. Optional kann es sich bei der optischen Komponenten bspw. um eine photonisch integrierte Schaltung handeln. Bspw. in diesem Fall, kann die LCI-Laseranordnung optisch mit der photonisch integrierten Schaltung gekoppelt sein und dazu ausgebildet sein die photonisch integrierte Schaltung mit Laserstrahlung zu versorgen. Anders ausgedrückt können die LCI-Anordnung und die PIC monolithisch so auf dem Substrat angeordnet sein, dass die LCI-Anordnung Laserstrahlung in die PIC einkoppeln kann. Beispielsweise durch den erfindungsgemäßen Einsatz und die entsprechende Anordnung der Zwischenschicht und dem darin enthaltenen Hohlraum kann ein Substrat 510 verwendet werden, welches sich für eine einfach Herstellung und gut handhabbare Integration von optischen Komponenten eignet, sodass bspw. eine sehr hohe Integrationsdichte auf dem gemeinsamen Substrat erzielt werden kann.

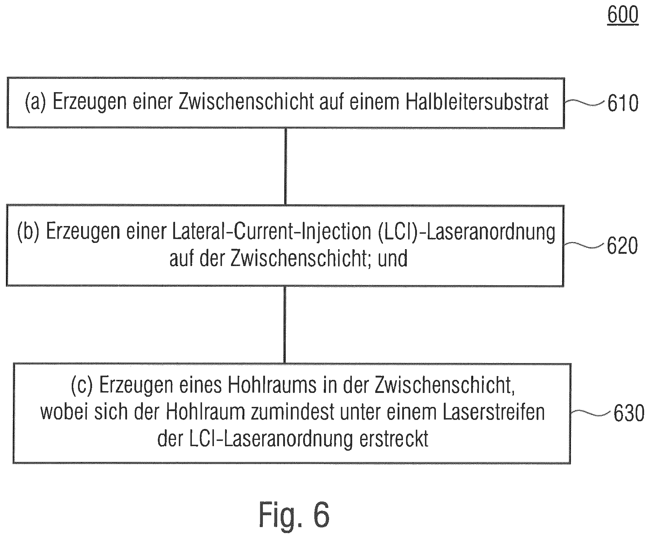

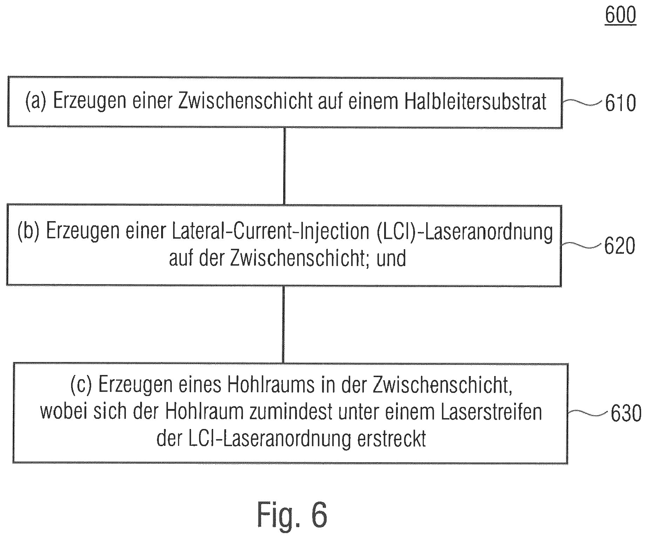

Fig. 6 zeigt ein schematisches Blockdiagramm eines Verfahren zur Herstellung einer Vorrichtung zur Erzeugung einer Laserstrahlung gemäß Ausführungsbeispielen der vorliegenden Erfindung. Verfahren 600 umfasst ein (a) Erzeugen 610 einer Zwischenschicht auf einem Halbleitersubstrat, ein (b) Erzeugen 620 einer Lateral-Current-Injection (LCI)-Laseranordnung auf der Zwischenschicht und ein (c) Erzeugen 630 eines Hohlraums in der Zwischenschicht, wobei sich der Hohlraum zumindest unter einem Laserstreifen der LCI-Laseranordnung erstreckt.

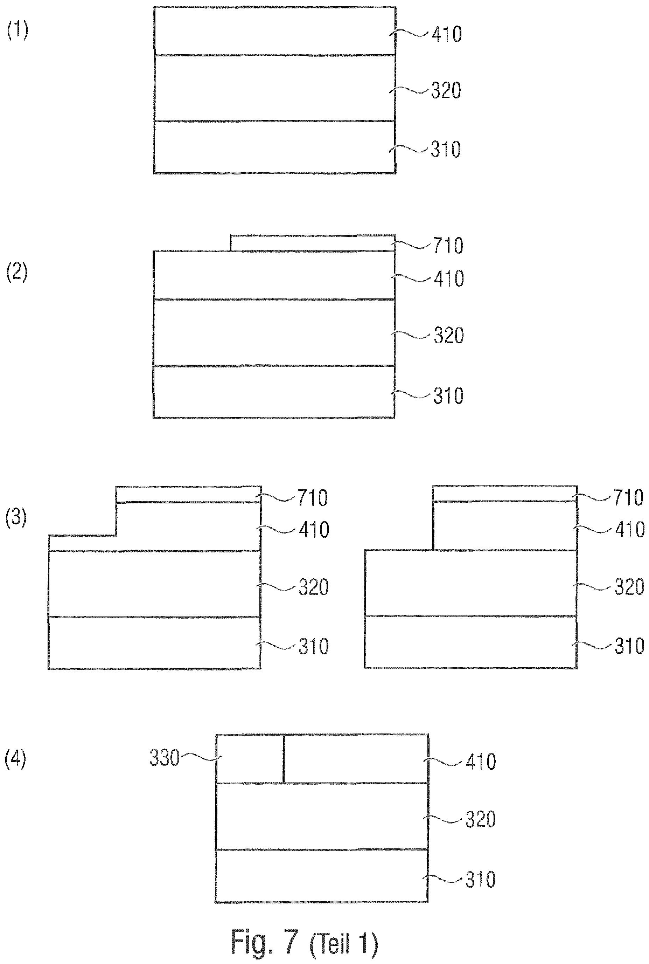

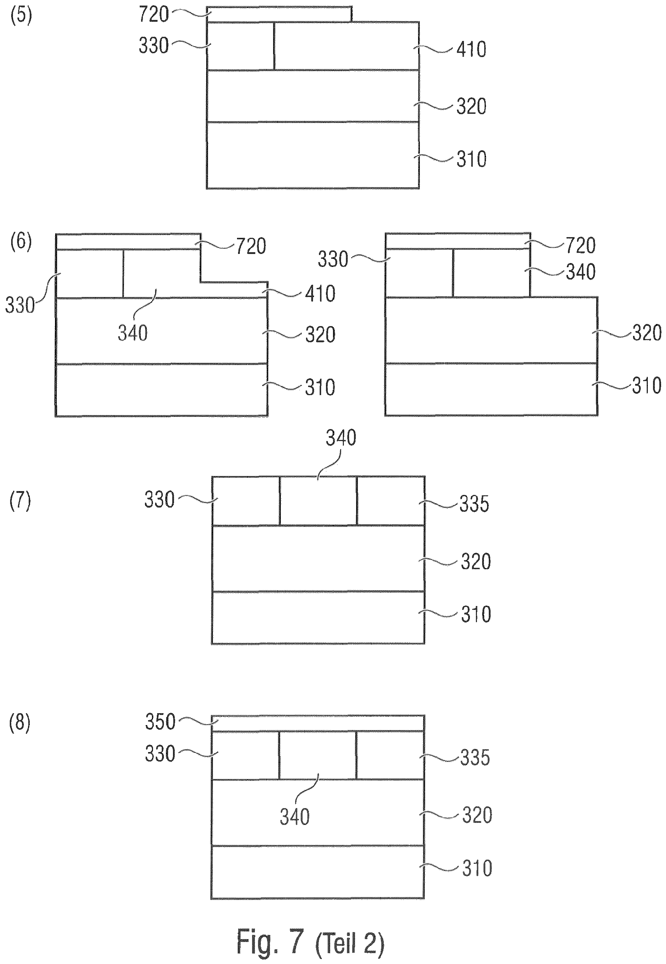

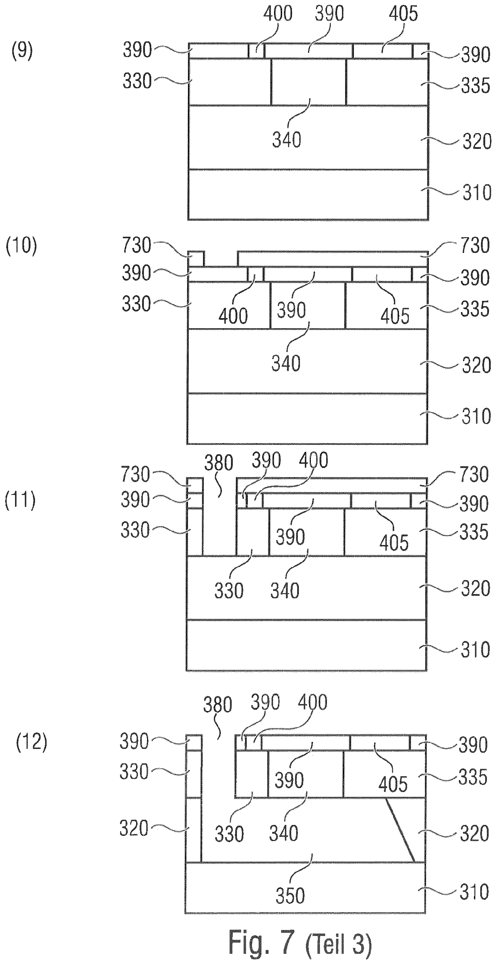

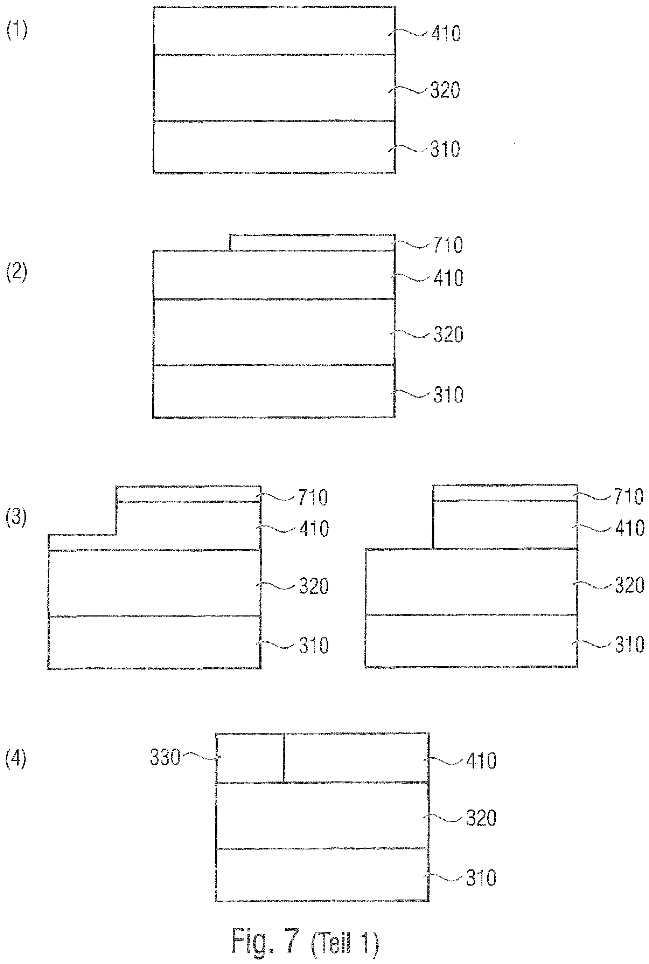

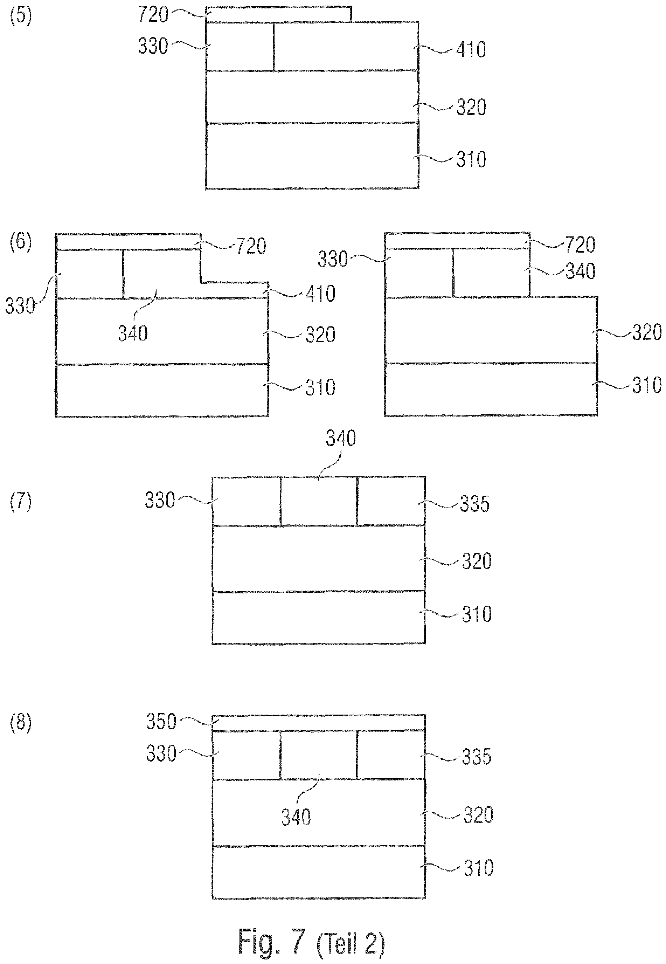

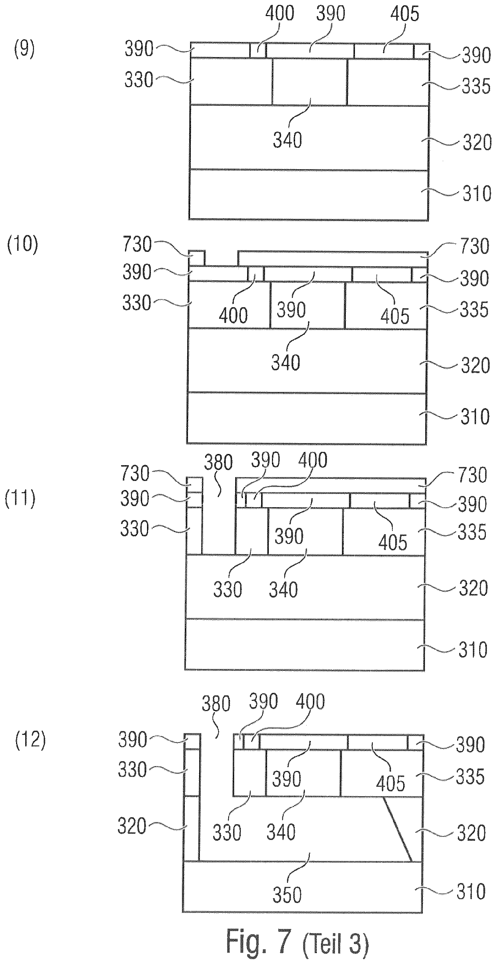

Fig. 7 zeigt schematische Seitenansichten von Herstellungsschritten eines Verfahrens gemäß der vorliegenden Erfindung zur Herstellung einer Vorrichtung zur Erzeugung einer Laserstrahlung. Erfindungsgemäße Aspekte von Herstellungsverfahren gemäß Ausführungsbeispielen werden im Folgenden bezugnehmend auf die in Fig. 6 gezeigten Schritte und mit Hilfe von Fig. 7 näher erläutert.

Fig. 7 (1) zeigt ein Halbleitersubstrat 310, auf welchem gemäß Schritt (a) eine Zwischenschicht 320 angeordnet ist. Zur Erzeugung der Lateral-Current-Injection (LCI)-Laseranordnung auf der Zwischenschicht kann eine Schichtfolge 410 auf der Zwischenschicht 320 angeordnet werden. Wie bereits zuvor erläutert umfasst die Schichtfolge 410 eine Mehrzahl von Schichten, welche in der erfindungsgemäßen Vorrichtung den Laserstreifen der LCI-Laseranordnung bilden.

Zur Erzeugung des Laserstreifens können ferner Teile der Schichtfolge 410 gedünnt oder entfernt werden. Dies kann wie als Beispiel in Fig. 7 (2) gezeigt ein Aufbringen einer ersten Ätzmaske (lithographische Maskierung) 710, durch ein lithographisches Verfahren, auf die Schichtfolge 410 umfassen. Die Ätzmaske 710 kann die darunterliegenden Schichten vor einer folgenden, zumindest partiellen Entfernung des unmaskierten Teils der Schichtfolge schützen. Fig. 7 (3) zeigt zwei mögliche erfindungsgemäße Resultate der Abtragung des unmaskierten Teils der Schichtfolge 410. Wie in Fig. 7 (3) links gezeigt kann das Entfernen dahingehend unvollständig durchgeführt werden, dass die Zwischenschicht nicht durch das Entfernen freigelegt wird. In Fig. 7 (3) rechts ist der Fall gezeigt in dem, bspw. durch Ätzen, bis auf die Zwischenschicht hinab, die darüberliegenden Schichtfolge entfernt wurde. Durch ein Dünnen oder partielles Abtragen kann bspw. Zeit für einen Ätzschritt eingespart werden.

Nach der Abtragung ist der Laserstreifen der LCI-Anordnung zumindest zu einem ersten Teil definiert.

Die Erläuterung der weiteren optionalen Prozessschritte wird als Beispiel mit Fig. 7 (3) rechts weitergeführt.

Anschließend kann wie in Fig. 7 (4) gezeigt ein Anordnen eines Halbleitermaterials mit einer ersten Dotierung auf dem einem ersten Bereich der Zwischenschicht erfolgen, so dass ein erster Bereich 330 der LCI-Laseranordnung definiert ist. Das Anordnen des Halbleitermaterials kann dabei durch epitaktisches Anwachsen durchgeführt werden. Wie in Fig. 7 (4) gezeigt kann nach dem epitaktischen Anwachsen die erste Ätzmaske 710 entfernt werden.

Analog kann wie in Fig. 7 (5)-(7) gezeigt ein Halbleitermaterial mit einer zweiten, von der ersten Dotierung unterschiedlichen Dotierung, auf einem zweiten Bereich der Zwischenschicht 320 angeordnet werden, so dass ein zweiter Bereich 335 der LCI-Laseranordnung definiert ist. Dazu kann wiederum eine Ätzmaske (lithographische Maskierung) 720, durch ein lithographisches Verfahren, auf einen Bereich der Schichtfolge, welcher den Laserstreifen der LCI-Laseranordnung bildet, und auf das Halbleitermaterial mit der ersten Dotierung im ersten Bereich der LCI-Laseranordnung aufgebracht werden, zumindest partiell der unmaskierte Teil der Schichtfolge gedünnt oder entfernt werden und das Halbleitermaterial mit der zweiten Dotierung bspw. mittels Epitaxie angewachsen werden, bevor die zweite lithographische Ätzmaske 720 wieder entfernt wird. Damit ist auch der Laserstreifen 340 der LCI-Anordnung definiert. Für die weiteren Erläuterungen wird Fig. 7 (6) rechts weiter betrachtet, also der Fall, dass die Zwischenschicht freigelegt wird, vor dem Anwachsen des Bereichs zweiter Dotierung.

Optional (nicht gezeigt in Fig. 7) kann das das Aufbringen der ersten und/oder zweiten Ätzmaske ferner ein Aufbringen einer Materialschicht auf zumindest einen Teil der Schichtfolge umfassen. Die Ätzmasken 710 bzw. 720 können dann durch ein lithographisches Verfahren auf zumindest einen Teil der Materialschicht aufgebracht werden. Bspw. mit einem Ätzschritt zur Abtragung der Zwischenschicht kann anschließend ein partielles Entfernen der Materialschicht außerhalb des zumindest einen Teils der Materialschicht erfolgen.

Nochmals in anderen Worten zusammengefasst kann in den Schritten von Fig. 7 (3) und (6) links die Schichtfolge (410) in einem ersten bzw. zweiten Bereich der Schichtfolge (410) ausgedünnt werden. In diesem ersten/zweiten Bereich kann anschließend epitaktisch das jeweilige dotierte Halbleitermaterial angewachsen werden.

Alternativ (Fig. 7 (3) und (6) rechts) kann die Schichtfolge in dem ersten bzw. zweiten Bereich der Schichtfolge (410) entfernt oder sogar vollständig entfernt werden, sodass die Zwischenschicht 320 freigelegt wird. Anders ausgedrückt kann ein erster und zweiter Bereich der Zwischenschicht 320 freigelegt werden. Das epitaktische Anwachsen des jeweiligen dotierten Halbleitermaterials kann dann auf einem ersten und zweiten freigelegten Bereich der Zwischenschicht 320 erfolgen, was wiederum einem Anwachsen des Halbleitermaterials in dem ersten und zweiten Bereich der Schichtfolge entspricht, der entfernt bzw. ausgedünnt wurde.

Die dotierten Halbleiterbereiche 330, 335 bilden jeweils den ersten und zweiten Bereich der LCI-Laseranordnung. Der erste/zweite Bereich der LCI-Laseranordnung entspricht dann räumlich bspw. dem ersten/zweiten Bereich der Schichtfolge 410, welche gedünnt wurde.

Optional kann das Entfernen oder Dünnen eines Teils der Schichtfolge, wie bspw. in Fig. 7 (3) und (6) gezeigt, ein gerichtetes Trockenätzverfahren umfassen.

Als weiteres optionales Merkmal eines erfindungsgemäßen Herstellungsverfahrens kann wie in Fig. 7 (8) gezeigt eine Passivierungsschicht 390 auf die LCI-Laseranordnung aufgebracht werden.

Beispielsweise abschließend in Schritt (b) oder als Anfang von Schritt (c), kann im Folgenden wie in Fig. 7 (9) gezeigt die Erzeugung von Kontaktierungen 400, 405 für den ersten und zweiten Bereich 330, 335 der LCI-Laseranordnung erfolgen. Dazu kann bspw. ein Teil der Passivierungsschicht 390 entfernt werden und in den entfernten Berteichen kann die Kontaktierung abgeschieden oder angeordnet werden. Hierzu können bspw. wiederum lithographische Maskierungen bzw. Ätzmasken und ein Ätzprozesse verwendet werden.

Bspw. im Folgenden, kann der Hohlraum erzeugt werden. Der Hohlraum wird in der Zwischenschicht 320, zumindest unter dem Laserstreifen 340 der LCI-Laseranordnung erzeugt. Dazu kann wie in Fig. 7 (10)-(11) gezeigt zuerst eine Tunnelstruktur 380 erzeugt werden. Die Tunnelstruktur 380 kann wie zuvor erläutert im ersten und/oder im zweiten Bereich der LCI-Laseranordnung erzeugt werden, sodass sie sich von der, der Zwischenschicht 320 gegenüberliegenden, Oberfläche der LCI-Laseranordnung bis zur Zwischenschicht 320 erstreckt, um die Zwischenschicht 320 zumindest teilweise freizulegen.

Als Beispiel kann hierzu wie in Fig. 7 (10) gezeigt eine dritte Ätzmaske (lithographische Maske) 730, durch ein lithographisches Verfahren, auf der LCI-Laseranordnung aufgebracht oder angeordnet oder abgeschieden werden. Bspw. mit Hilfe eines Ätzverfahrens, wie bspw. einem Trockenätzverfahren, kann die zumindest eine Tunnelstruktur 380 im unmaskierten Bereich der LCI-Laseranordnung erzeugt werden, siehe z.B. Fig. 7 (11).

Die Tunnelstruktur 380 kann anschließend dazu verwendet werden den Hohlraum 350 (siehe Fig. 7 (12)) in der Zwischenschicht 320 zu erzeugen. Dazu kann eine selektive Ätzlösung in die Tunnelstruktur 380 eingebracht werden, sodass die Ätzlösung die Zwischenschicht zumindest in einem Bereich unterhalb des Laserstreifens 340 wegätzt. Ferner kann die dritte lithographische Maske wiederum entfernt werden.

Wie bereits in Bezug auf die erste und zweite lithographische Maske 710, 720 erläutert kann auch für die dritte Maske 730 zuerst eine Materialschicht auf zumindest einen Teil der LCI-Laseranordnung oder auf einen Teil der Passivierungsschicht und der ersten und zweiten Kontaktierung aufgebracht werden, sodass anschließend eine dritte Ätzmaske durch ein lithographisches Verfahren auf zumindest einem Teil der Materialschicht erzeugt werden kann. Der folgende Ätzschritt, bspw. zur Erzeugung der Tunnelstruktur 380, umfasst dann bspw. ein partielles Entfernen der Materialschicht außerhalb des zumindest einen Teils der Materialschicht.

Mit Hilfe der Tunnelstruktur 380 kann ferner der Hohlraum 350 mit einem flüssigen Füllstoff aufgefüllt werden. Der Füllstoff kann anschließend bspw. aushärten oder ausgehärtet werden (nicht gezeigt in Fig. 7).

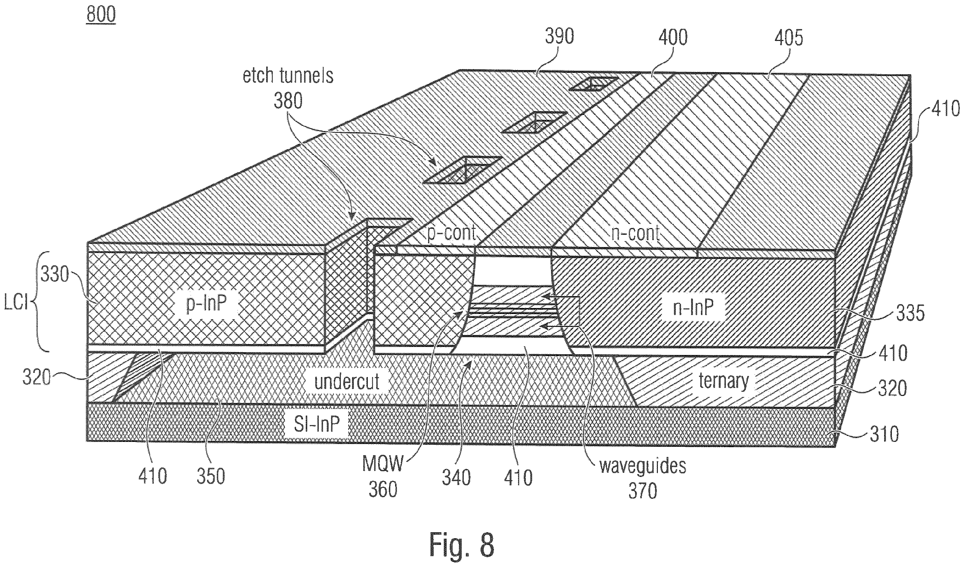

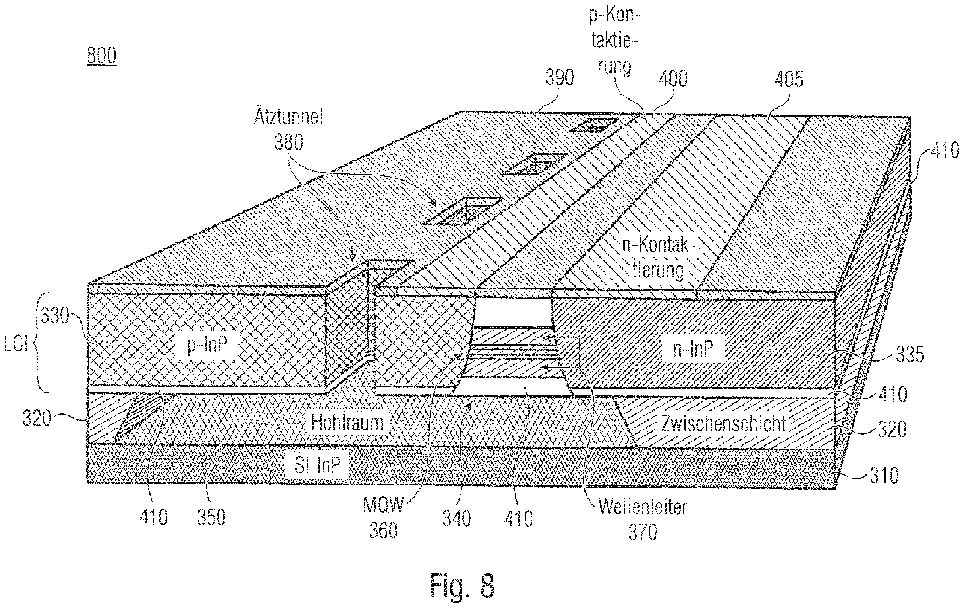

Fig. 8 zeigt eine schematische Seitenansicht einer alternativen Ausführungsform der Vorrichtung aus Fig. 3, bei der die Schichtfolge nur jeweils partiell entfernt wurde, gemäß Ausführungsbeispielen der vorliegenden Erfindung. Fig. 8 zeigt Vorrichtung 800 mit bereits zuvor erläuterten Merkmalen. Entsprechend den in Fig. 7 (3) und (6) jeweils links gezeigten Varianten der Entfernung der Schichtfolge 410 kann Vorrichtung 800 im Vergleich zu Vorrichtung 300 noch entsprechende Abschnitte der Schichtfolge 410 unterhalb der dotierten Halbleiter n-lnP und p-lnP aufweisen. Durch zeitlich verkürzte Ätzschritte kann eine erfindungsgemäße Vorrichtung 800 bspw. mit geringerem Zeitaufwand erzeugt werden.

Im Gegensatz zu allen bisher bekannten Lösungen ermöglichen erfindungsgemäße Konzepte neue Verfahren zur Herstellung von LCI-Laserchips mit lokal unterhöhlter Membranstruktur (bspw. die LCI-Laseranordnung), die bspw. erstmals auch die monolithische Integration mit anderen optischen und elektrischen Komponenten auf einem InP-Substrat erlauben. Eine solche Membranstruktur dient bspw. dazu, das optische Confinement (optische Begrenzung) in den aktiven Schichten signifikant zu erhöhen, oder z.B. anders ausgedrückt eine gute optische Begrenzung der erzeugten Lasterstrahlung im Laserstreifen der LCI-Laseranordnung zu ermöglichen, und dadurch sehr kleine Laserschwellströme und damit verbunden auch einen sehr kleinen Energieverbrauch der Laser zu erreichen. Durch Verwendung von semi-isolierenden Welleneiterschichten ober- und unterhalb der aktiven Schichten lassen sich kleine Leck/Verlustströme in solchen Strukturen erreichen. Als Beispiel für eine solche erfindungsgemäße Vorrichtung sei nochmals auf Fig. 3 verwiesen.

Wie bereits zuvor erläutert kann die Membranstruktur erfindungsgemäß dadurch realisiert werden, dass sich unterhalb des Laserstreifens eine selektiv ätzbare Opfer-Schicht (bspw. Zwischenschicht) befindet, die während des Laser-Herstellungsprozesses chemisch entfernt wird. Dadurch verbleibt der LCI-Laser bzw. die LCI-Laseranordnung auf dem InP-Substrat und kann mit anderen optischen Komponenten monolithisch integriert werden.

Weitere Vorteile des erfindungsgemäßen Konzepts, bspw. im Hinblick auf bisherige Lösungen aus dem Stand der Technik, bilden bspw.:
- Die zu entfernende Opferschicht befindet sich gemäß Ausführungsbeispielen optional direkt unterhalb der Laserstruktur und formt diese zu einem Membranlaser. Die Opferschicht befindet sich also bspw. in einem geringen Abstand zur Laserstruktur und verändert also bspw. im Vergleich zu bisherigen Ansätzen die Laserstruktur selbst.
- Ein Vorteil oder bspw. der Zweck des erfindungsgemäß geformten Hohlraums ist die Vergrößerung des optischen Confinements durch Einengung der Lasermode. In anderen Worten wird die Lasermode optisch beeinflusst oder verbessert durch den Hohlraum.

Im Folgenden werden Details zu Beispielen von erfindungsgemäßen Herstellungsverfahren in anderen Worten noch einmal zusammengefasst:
Zunächst kann auf der Zwischenschicht, bspw. einer Opferschicht (ternäre Schicht, InGaAs) die Laserstruktur bspw. die LCI-Laseranordnung realisiert werden. Diese besteht z.B. aus einem Multi-Quantum-Well- (MQW-) Paket mit oberhalb und unterhalb gelegenen Wellenleiterschichten und seitlich angrenzenden p- und n-dotierten InP-Bereichen.

In einem der dotierten Bereiche können durch ein gerichtetes Trockenätzverfahren Tunnelstrukturen bzw. Tunnel geätzt werden, bspw. um dort die Zwischenschicht bzw. Opferschicht freizulegen. Ausgehend von diesen Tunnelstrukturen oder z.B. einfach ausgedrückt Öffnungen kann anschließend mit einer selektiv ätzenden Lösung die Zwischenschicht (bspw. ternäre Opferschicht in Fig. 3) teilweise entfernt werden, sodass sich unterhalb des MQW- und Wellenleiter-Pakets ein Hohlraum bildet. Die Breite dieses Hohlraumes kann durch die Ätzzeit bestimmt werden.

Dieser Hohlraum kann im fertigen Laserchip durch seinen geringen Brechungsindex, bspw. durch ein Gas als Füllmaterial (Luft: n=1), oder bspw. durch ein anderes niedrigbrechendes Füllmaterial, ein vertikales Aufweiten der optischen Mode verhindern und kann damit signifikant das optische Confinement in den MQW-Schichten erhöhen. Die Effizienz des Lasers kann damit wesentlich verbessert werden.

Ganz allgemein können erfindungsgemäße Herstellungsverfahren beispielsweise folgende Prozessschritte zur Herstellung eines unterhöhlten Membranlasers umfassen:
1. Epitaxie
   Epitaktisches Wachstum mindestens folgender Schichten auf einen Wafer (Substrat):
   - Selektiv ätzbare Opferschicht (Zwischenschicht). Diese Schicht kann oder bspw. muss mit einer Ätzlösung abtragbar sein, während die später anzuwachsenden n- und p-leitenden Bereiche NICHT abtragbar sind. Z.B. InGaAs (Indiumgalliumarsenid), welches mit Schwefelsäure antragbar ist, InP aber nicht.
   - Schichtpaket, bestehend aus Schichten mit unterschiedlicher Bandlücke, die später als aktives Medium und Wellenleiter fungieren. Hier z.B. die Folge
      ∘ Buffer aus InP
      ∘ Wellenleiter aus InGaAsP (Indiumgalliumarsenidphosphid)
      ∘ abwechselnd mehrere Quantentöpfe und Barrieren aus InGaAsP
      ∘ Wellenleiter aus InGaAsP
      ∘ Buffer aus InP.
2. Herstellung der lateralen Laser-Struktur: N-Leiter, aktiver Laserstreifen, P-Leiter Hier z.B. durch folgende Prozess-Abfolge:
   - lithografische Maskierung des Laserstreifens und eines seitlich direkt angrenzenden Bereichs
   - Abtragen des unmaskierten Bereichs, z.B. mittels gerichteter Trockenätzung.
   - Epitaktisches Anwachsen eines der Bereiche n-lnP oder p-lnP.
   - Entfernen der Maskierung und lithografisches Aufbringen einer neuen Maske, die den Laserstreifen und den auf der anderen Seite direkt angrenzenden Bereich bedeckt.
   - Abtragen des unmaskierten Bereichs, z.B. mittels gerichteter Trockenätzung
   - Epitaktisches Anwachsen des anderen der Bereiche n-lnP oder p-lnP.
3. Kontaktherstellung
   Herstellung je eines Metallkontakts auf dem n-leitenden und p-leitenden Bereich seitlich entlang des Laserstreifens, z.B. mittels Sputtern und Galvanik.
4. Unterhöhlung des Laserstreifens
   Hier z.B. durch folgende Prozess-Abfolge:
   - Herstellung eines Zugangs (Tunnelstruktur) für die selektive Ätzlösung zur Opferschicht (ein oder mehrere seitlich neben dem Laserstreifen gelegene senkrechte Tunnel) mittels lithografischer Maskierung der Oberfläche und anschließender gerichteter Trockenätzung.
   - Eintauchen in die selektive Ätzlösung für eine Zeit, die ausreicht um die Opferschicht unterhalb des Laserstreifens komplett abzutragen.

Insbesondere die Schritte 3. und 4. können bspw. auch in umgekehrter Reihenfolge durchgeführt werden.

Weitere Wirkungen und Vorteile erfindungsgemäßer Konzepte umfassen die Möglichkeit LCI-Laser mit Membran-Bauform monolithisch mit anderen optischen Komponenten auf einem InP-Substrat zu integrieren, also bspw. eine Vorrichtung zur Erzeugung von Laserstrahlung gemäß Ausführungsbeispielen monolithisch mit PICs auf InP-Substraten zu integrieren. Anders ausgedrückt kann mit den erfindungsgemäßen, neuen Herstellungsverfahren genau dies ermöglicht werden. Ausführungsbeispiele adressieren oder erfüllen das Ziel, bspw. erstmals, eine schwebende LCI-Membranstruktur auf InP zu realisieren, die direkt mit passiven Wellenleitern, Kopplern usw. monolithisch integriert werden kann. Bisher demonstrierte LCI-Membranstruktur-Herstellung mittels einer vollständigen Entfernung des InP-Substrates und anschließendem Waferbonden auf ein anderes Substrat [4] [5] [6] (z.B. Si oder SiNx) kann hier komplett entfallen.

Somit ermöglichen Konzepte gemäß Ausführungsbeispielen Verbesserungen und neue Einsatzmöglichkeiten in einer Vielzahl von technischen Anwendungsgebieten:
Erfindungsgemäße LCI-Laser sind aufgrund ihrer geringen Betriebsleistung speziell für PICs mit einer hohen Integrationsdichte interessant, wie sie z.B. in Neuromorphic Photonics, in der Quantentechnologie oder auch in optischen Datennetzen benötigt werden. Beispielsweise im Unterschied zu den bereits bekannten VCSEL-Arrays [7], erlauben auf dem erfindungsgemäßen LCI-Ansatz basierende Arrays unterschiedliche Emissionswellenlängen pro Laser, bspw. auch bei gleichem Strom, und können somit als Multi-Wavelength-Arrays auch bspw. für Wavelength-division multiplexing (WDM)-Anwendungen genutzt werden.

Darüber hinaus ermöglicht die erfindungsgemäße schwebende Laserstruktur, solche LCI-Laser monolithisch mit anderen aktiven und passiven optischen Komponenten auf InP-Wafern zu integrieren. LCI Laser können daher aktuelle InP basierende Integrationsplattformen im Hinblick auf PICs mit hoher Integrationsdichte wesentlich ergänzen und dadurch völlig neue hochintegrierte Anwendungen ermöglichen, die mit herkömmlichen edge-emitting (kantenemittierenden) Lasern aufgrund des zu hohen Wärmeeintrags nicht realisierbar sind.

Alle hierin aufgeführten Aufzählungen der Materialien, Umwelteinflüsse, elektrischen Eigenschaften und optischen Eigenschaften sind hierbei als beispielhaft und nicht als abschließend anzusehen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Referenzen

[1] Y. Shen, N. C. Harris, S. Skirlo, M. Prabhu, T. Baehr-Jones, M. Hochberg, X. Sun, S. Zhao, H. Larochelle, D. Englund und others, "Deep learning with coherent nanophotonic circuits," Nature Photonics, Bd. 11, p. 441, 2017.
[2] L. De Marinis, M. Cococcioni, P. Castoldi und N. Andriolli, "Photonic neural networks: a survey," IEEE Access, Bd. 7, pp. 175827-175841, 2019.
[3] T. Hiratani, K. Doi, Y. Atsuji, T. Amemiya, N. Nishiyama und S. Arai, "Low-power and high-speed operation capabilities of semiconductor membrane lasers-Energy cost limited by Joule heat," in 26th International Conference on Indium Phosphide and Related Materials (IPRM), 2014.
[4] S. Matsuo, T. Fujii, K. Hasebe, K. Takeda, T. Sato und T. Kakitsuka, "Ultralow operating energy of directly modulated DFB laser on SiO 2/Si substrate," in Optical Communication (ECOC), 2014 European Conference on, 2014.
[5] N.-P. P. Diamantopoulos, S. Yamaoka, T. Fujii, H. Nishi, K. Takeda, T. Tsuchizawa, T. Kakitsuka und S. Matsuo, "47.5 GHz Membrane-III-V-on-Si Directly Modulated Laser for Sub-pJ/bit 100-Gbps Transmission," in Photonics, 2021.
[6] D. Inoue, T. Hiratani, K. Fukuda, T. Tomiyasu, T. Amemiya, N. Nishiyama und S. Arai, "Low-bias current 10 Gbit/s direct modulation of GaInAsP/InP membrane DFB laser on silicon," Optics express, Bd. 24, pp. 18571-18579, 2016.
[7] W. Hofmann, E. Wong, G. Bohm, M. Ortsiefer, N. H. Zhu und M. C. Amann, "1.55-mu m VCSEL Arrays for High-Bandwidth WDM-PONs," IEEE Photonics Technology Letters, Bd. 20, pp. 291-293, 2008.
[8] "DBR laser with improved thermal tuning efficiency". Patent 8236590 B2, 2012.
[9] N.-P. Diamantopoulos, H. Yamazaki, S. Yamaoka, M. Nagatani, H. Nishi, H. Tanobe, R. Nakao, T. Fujii, K. Takeda, T. Kakitsuka und others, "> 100-GHz Bandwidth Directly-Modulated Lasers and Adaptive Entropy Loading for Energy-Efficient> 300-Gbps/λ IM/DD Systems," Journal of Lightwave Technology, Bd. 39, pp. 771-778, 2021.

## Patentansprüche

1. Vorrichtung (200, 300, 400, 500, 501) zur Erzeugung einer Laserstrahlung mit
einem Halbleitersubstrat (210, 310, 510),
einer auf dem Halbleitersubstrat angeordneten Zwischenschicht (220, 320); und
einer Lateral-Current-Injection (LCI)-Laseranordnung, die auf der Zwischenschicht (220, 320) angeordnet ist,
wobei die Zwischenschicht (220, 320) einen Hohlraum (240, 350) umfasst, der sich zumindest unter einem Laserstreifen (230, 340) der LCI-Laseranordnung erstreckt.

2. Vorrichtung gemäß Anspruch 1, wobei die Zwischenschicht unmittelbar auf dem Halbeitersubstrat angeordnet ist.

3. Vorrichtung (200, 300, 400, 500, 501) gemäß einem der Ansprüche 1 oder 2,
wobei der Hohlraum dazu ausgebildet ist die Laserstrahlung in dem Laserstreifen (230, 340) der LCI-Laseranordnung optisch zu begrenzen.

4. Vorrichtung (200, 300, 400, 500, 501) gemäß einem der vorigen Ansprüche,
wobei die LCI-Laseranordnung einen ersten Bereich (330) mit einer ersten Dotierung umfasst, und
wobei die LCI-Laseranordnung einen zweiten Bereich (335) mit einer zweiten Dotierung umfasst,
wobei die erste und zweite Dotierung unterschiedlich sind; und
wobei der Laserstreifen (230, 340) der LCI-Laseranordnung lateral zwischen dem ersten Bereich (330) und dem zweiten Bereich (335) der LCI-Laseranordnung angeordnet ist, und
wobei der Laserstreifen (230, 340) dazu ausgebildet ist, um basierend auf einem lateral, mittels des ersten und zweiten Bereichs, eingespeisten Strom die Laserstrahlung zu erzeugen;; und wobei die LCI-Laseranordnung zumindest eine Tunnelstruktur (380) aufweist,
wobei die zumindest eine Tunnelstruktur (380) im ersten und/oder im zweiten Bereich (330, 335) der LCI-Laseranordnung angeordnet ist; und
wobei sich die zumindest eine Tunnelstruktur (380) vom Hohlraum (240, 350) in der Zwischenschicht (220, 320) bis zu der, der Zwischenschicht gegenüberliegenden, Oberfläche der LCI-Laseranordnung erstreckt.

5. Vorrichtung (200, 300, 400, 500, 501) gemäß einem der vorigen Ansprüche,
wobei die Vorrichtung eine Passivierungsschicht (390) umfasst, und
wobei die Passivierungsschicht (390) zumindest teilweise auf der, der Zwischenschicht (220, 320) gegenüberliegenden Oberfläche der LCI Laseranordnung angeordnet ist.

6. Vorrichtung (200, 300, 400, 500, 501) gemäß einem der vorigen Ansprüche,
wobei die Vorrichtung eine erste Kontaktierung (400) und eine zweite Kontaktierung (405, 505) umfasst,
wobei die erste Kontaktierung (400) auf dem ersten Bereich (330) der LCI-Laseranordnung angeordnet ist, und
wobei die erste Kontaktierung (400) dazu ausgebildet ist einen elektrischen Kontakt zu dem ersten Bereich (330) der LCI-Laseranordnung zu ermöglichen, und
wobei die zweite Kontaktierung (405, 505) auf dem zweiten Bereich (335) der LCI-Laseranordnung angeordnet ist, und
wobei die zweite Kontaktierung (405, 505) dazu ausgebildet ist einen elektrischen Kontakt zu dem zweiten Bereich (335) der LCI-Laseranordnung zu ermöglichen; und
wobei die erste Kontaktierung (400) lateral zwischen der Tunnelstruktur (380) und dem Laserstreifen (230, 340) der LCI-Laseranordnung angeordnet ist; und/oder
wobei die erste Kontaktierung (400) lateral an einer, dem Laserstreifen (230, 340) gegenüberliegenden, Seite der Tunnelstruktur (380) der LCI-Laseranordnung angeordnet ist; und/oder
wobei die zweite Kontaktierung (405, 505) lateral zwischen der Tunnelstruktur (380) und dem Laserstreifen (230, 340) der LCI-Laseranordnung angeordnet ist und/oder
wobei die zweite Kontaktierung (405, 505) lateral an einer, dem Laserstreifen (230, 340) gegenüberliegenden, Seite der Tunnelstruktur (380) der LCI-Laseranordnung angeordnet ist.

7. Vorrichtung (200, 300, 400, 500, 501) gemäß Anspruch 64,
wobei die Vorrichtung eine Kontaktierungsschicht (510) umfasst,
wobei die Kontaktierungsschicht (510) ein dotiertes Halbleitermaterial (520) aufweist, und
wobei die Kontaktierungsschicht (510) auf der, der Zwischenschicht (220, 320) gegenüberliegenden, Oberfläche des Substrats (210, 310, 510) angeordnet ist; und
wobei die Kontaktierungsschicht (510) eine dritte Kontaktierung (530) umfasst,
wobei die dritte Kontaktierung (530) dazu ausgebildet ist einen elektrischen Kontakt zu der Kontaktierungsschicht (510) zu ermöglichen; und
wobei sich die erste Kontaktierung (400) vom ersten Bereich (330) der LCI-Laseranordnung bis zur Kontaktierungsschicht (510) erstreckt, und
wobei die dritte Kontaktierung (530) über das dotierte Halbleitermaterial (520) mit der ersten Kontaktierung (400) elektrisch leitfähig verbunden ist; oder
wobei sich die zweite Kontaktierung (405, 505) vom zweiten Bereich (335) der LCI-Laseranordnung bis zur Kontaktierungsschicht (510) erstreckt, und
wobei die dritte Kontaktierung (530) über das dotierte Halbleitermaterial (520) mit der zweiten Kontaktierung (405, 505) elektrisch leitfähig verbunden ist.

8. Vorrichtung (200, 300, 400, 500, 501) gemäß einem der vorigen Ansprüche,
wobei der Laserstreifen (230, 340) der LCI-Laseranordnung zumindest ein Multi-Quantum-Well-Paket (360) umfasst; und
wobei der Laserstreifen (230, 340) der LCI-Laseranordnung Wellenleiterschichten (370) umfasst; und
wobei die Wellenleiterschichten (370) semi-isolierende Wellenleiterschichten sind, und wobei die semi-isolierenden Wellenleiterschichten vertikal oberhalb und unterhalb des zumindest einen Multi-Quantum-Well-Paketes (360) angeordnet sind.

9. Vorrichtung (200, 300, 400, 500, 501) gemäß einem der vorigen Ansprüche, wobei der Hohlraum (240, 350) und/oder die zumindest eine Tunnelstruktur (380) einen Füllstoff aufweisen; und wobei der Füllstoff dazu ausgebildet ist die Laserstrahlung in dem Laserstreifen (230, 340) der LCI-Laseranordnung optisch zu begrenzen.

10. Vorrichtung (200, 300, 400, 500, 501) gemäß einem der vorigen Ansprüche,
wobei die Vorrichtung eine optische Komponente (530) umfasst, und wobei die optische Komponente und die LCI-Laseranordnung monolithisch auf dem Substrat (210, 310, 510) integriert sind; und wobei die optische Komponente (530) eine photonisch integrierte Schaltung ist; und
wobei die LCI-Laseranordnung optisch mit der photonisch integrierten Schaltung gekoppelt ist; und
wobei die LCI-Laseranordnung dazu ausgebildet ist die Laserstrahlung für die photonisch integrierte Schaltung bereitzustellen.

11. Verfahren (600) zur Herstellung einer Vorrichtung zur Erzeugung einer Laserstrahlung mit den folgenden Merkmalen:
(a) Erzeugen (610) einer Zwischenschicht (220, 320) auf einem Halbleitersubstrat (210, 310, 510);
(b) Erzeugen (620) einer Lateral-Current-Injection (LCI)-Laseranordnung auf der Zwischenschicht (220, 320); und
(c) Erzeugen (630) eines Hohlraums (240, 350) in der Zwischenschicht (220, 320), wobei sich der Hohlraum (240, 350) zumindest unter einem Laserstreifen (230, 340) der LCI-Laseranordnung erstreckt.

12. Verfahren (600) gemäß Anspruch 11, wobei der Schritt (b) ferner die folgenden Merkmale umfasst:
(b1) Erzeugen einer Schichtfolge (410) auf der Zwischenschicht (220, 320), wobei die Schichtfolge (410) eine Mehrzahl von Schichten eines Laserstreifens (230, 340) der LCI-Laseranordnung umfasst; und
(b2) Dünnen eines Teils der Schichtfolge (410)in einem ersten und zweiten Bereich der Schichtfolge (410), so dass der Laserstreifen (230, 340) der LCI-Laseranordnung definiert ist, und
(b3) Anordnen eines Halbleitermaterials mit einer ersten Dotierung in dem ersten Bereich, so dass ein erster Bereich (330) der LCI-Laseranordnung definiert ist, und
(b4) Anordnen eines Halbleitermaterials mit einer zweiten, von der ersten Dotierung unterschiedlichen Dotierung, in dem zweiten Bereich, so dass ein zweiter Bereich (335) der LCI-Laseranordnung definiert ist.

13. Verfahren (600) gemäß Anspruch 12, wobei der Schritt (b2) ein Entfernen des Teils der Schichtfolge (410) im ersten und zweiten Bereich der Schichtfolge umfasst, um einen ersten und zweiten Bereich der Zwischenschicht (220, 320) freizulegen.

14. Verfahren (600) gemäß einem der Ansprüche 11 bis 13, wobei der Schritt (c) ferner die folgenden Merkmale umfasst:
(c1) Erzeugen zumindest einer Tunnelstruktur (380) im ersten und/oder im zweiten Bereich (335) der LCI-Laseranordnung, wobei sich die zumindest eine Tunnelstruktur (380) von der, der Zwischenschicht (220, 320) gegenüberliegenden, Oberfläche der LCI-Laseranordnung bis zur Zwischenschicht (220, 320) erstreckt, um die Zwischenschicht zumindest teilweise freizulegen, und
(c2) Erzeugen des Hohlraums (240, 350) in der Zwischenschicht (220, 320) unter Verwendung der zumindest einen Tunnelstruktur.

15. Verfahren (600) gemäß einem der Ansprüche 11 bis 14, wobei das Verfahren ferner die folgenden Merkmale umfasst:
(d1) Auffüllen des Hohlraums (240, 350) und/oder der zumindest einen Tunnelstruktur (380) mit einem flüssigen Füllstoff, und
(d2) Aushärten des Füllstoffs.
